(19) Europäisches Patentamt
European Patent Office
Office européen des brevets

(11) **EP 1 530 295 B1**

(12) **EUROPÄISCHE PATENTSCHRIFT**

(45) Veröffentlichungstag und Bekanntmachung des Hinweises auf die Patenterteilung:
**18.10.2006 Patentblatt 2006/42**

(51) Int Cl.:
***H03M 1/12*** (2006.01)

(21) Anmeldenummer: **03025666.3**

(22) Anmeldetag: **07.11.2003**

(54) **Verfahren zur Analog-Digital-Wandlung und Analog-Digital-Wandler**

Analogue-to-digital conversion method and analogue-to-digital converter

Procédé pour la conversion analogique-numérique et convertisseur analogique-numérique

(84) Benannte Vertragsstaaten:
**AT BE BG CH CY CZ DE DK EE ES FI FR GB GR HU IE IT LI LU MC NL PT RO SE SI SK TR**

(43) Veröffentlichungstag der Anmeldung:
**11.05.2005 Patentblatt 2005/19**

(73) Patentinhaber: **Delphi Technologies, Inc.**
**Troy, MI 48007 (US)**

(72) Erfinder:
• **Giesen, Marko**
**51588 Nümbrecht (DE)**
• **Trommer, Frank O.**
**51588 Nümbrecht (DE)**
• **Lehmann, Klaus**
**53797 Lohmar (DE)**
• **Stadler, Peter**
**57482 Wenden (DE)**
• **Schulte, Thomas**
**58540 Meinerzhagen-Windebruch (DE)**
• **Markus, Heinrich**
**51588 Nümbrecht (DE)**

(74) Vertreter: **Manitz, Finsterwald & Partner GbR**
**Postfach 31 02 20**
**80102 München (DE)**

(56) Entgegenhaltungen:
**WO-A-90/11613                US-A- 5 801 657**

• **CLIFF R A: "DIGITAL MULTIPLEXING OF ANALOG DATA IN A MICROPROCESSOR CONTROLLED DATA ACQUISITION SYSTEM" IEEE JOURNAL OF SOLID-STATE CIRCUITS, IEEE INC. NEW YORK, US, Bd. SC-15, Nr. 1, Februar 1980 (1980-02), Seiten 136-138, XP000798099 ISSN: 0018-9200**

## Beschreibung

Die vorliegende Erfindung betrifft ein Verfahren zur Wandlung von Analogsignalen wenigstens zweier Kanäle in entsprechende, jeweils deren Pegel darstellende Digitalsignale gemäß dem Oberbegriff des Anspruchs 1 sowie einen entsprechenden Analog-Digital-Wandler. Ein Verfahren mit den Merkmalen des Oberbegriffs des Anspruchs 1 ist aus der US 5,801,657 bekannt.

Bei der Messung physikalischer Größen oder der Steuerung und/oder Regelung technischer Vorrichtungen treten oft Analogsignale auf, die durch eine quantitative Eigenschaft, beispielsweise deren Amplitude bzw. Pegel, den Wert einer gemessenen oder zu steuernden Größe darstellen. Zur einfachen Verarbeitung der Messwerte ist es häufig günstiger, zu einer digitalen Darstellung der Messwerte überzugehen, wozu die Analogsignale in grundsätzlich bekannter Art und Weise mittels eines Analog-Digital-Wandlers in beispielsweise einen Pegel der Analogsignale darstellende Digitalsignale umgewandelt werden. Der Pegel kann insbesondere als Digitalwert mit einer vorgegebenen Anzahl von Bits dargestellt werden.

Insbesondere im Bereich des Fahrzeugbaus werden immer häufiger Sensoren zur Messung physikalischer Größen verwendet, die analoge Signale abgeben, die wiederum digital zu verarbeiten sind. Dabei werden zwei sich widersprechende Anforderungen an die hierzu zu verwendenden Verfahren zur Analog-Digital-Wandlung bzw. an entsprechende Analog-Digital-Wandler gestellt. Zum einen soll die Wandlung der Analogsignale in entsprechende Digitalsignale sehr schnell erfolgen, so dass Messwerte mit einer hohen Erfassungsfrequenz erfasst werden können. Dies wäre beispielsweise durch Verwendung jeweils eines schnellen Analog-Digital-Wandlers für jeden Sensor bzw. Kanal für Signale des Sensors möglich.

Eine solche Lösung würde aber aufgrund der Anzahl von Sensoren und damit Kanälen der anderen Anforderung entgegenlaufen, wonach eine technisch möglichst einfache und kostensparende Vorrichtung zur Analog-Digital-Wandlung mehrerer Analogsignale wünschenswert ist.

Der vorliegenden Erfindung liegt daher die Aufgabe zugrunde, ein Verfahren zur Wandlung von Analogsignalen wenigstens zweier Kanäle in entsprechende, jeweils deren Pegel darstellende Digitalsignale sowie einen entsprechenden Analog-Digital-Wandler bereitzustellen, das bzw. der eine schnelle und mit geringem Schaltungsaufwand verbundene Analog-Digital-Wandlung erlaubt.

Die Aufgabe wird gelöst durch ein Verfahren zur Wandlung von Analogsignalen wenigstens zweier Kanäle in entsprechende, jeweils deren Pegel darstellende Digitalsignale mit den Merkmalen des Anspruchs 1.

Bei dem erfindungsgemäßen Verfahren zur Wandlung von Analogsignalen wenigstens zweier Kanäle in entsprechende, jeweils deren Pegel darstellende Digitalsignale wird ein Referenzsignal mit einem sich zeitlich ändernden Referenzpegel gebildet, und die Pegel der Analogsignale werden wenigstens zu verschiedenen Zeitpunkten im Wesentlichen parallel mit dem jeweiligen Referenzpegel des Referenzsignals verglichen. Für die Analogsignale werden jeweils entsprechende, das Ergebnis des jeweiligen Vergleichs wiedergebende Vergleichssignale gebildet und für jedes Analogsignal wird auf der Basis wenigstens eines der Vergleichssignale für das jeweilige Analogsignal ein dessen Pegel wiedergebendes Digitalsignal gebildet.

Die Aufgabe wird weiterhin gelöst durch einen Analog-Digital-Wandler mit den Merkmalen des Anspruchs 6.

Der erfindungsgemäße Analog-Digital-Wandler zur Wandlung von Analogsignalen wenigstens zweier Kanäle in entsprechende, jeweils deren Pegel darstellende Digitalsignale umfasst einen Referenzsignalgenerator zur Bildung eines zeitlich veränderlichen Referenzsignals und zur Abgabe des Referenzsignals über einen Referenzsignalausgang, jeweils einen Komparator für jeden der Kanäle, der einen Analogsignaleingang zur Zuführung des Analogsignals des entsprechenden Kanals und einen mit dem Referenzsignalausgang verbundenen Referenzsignaleingang aufweist und mittels dessen der Pegel des jeweiligen Analogsignals mit einem Referenzpegel des Referenzsignals vergleichbar und ein entsprechendes, ein Ergebnis des Vergleichs wiedergebendes Vergleichssignal über einen Vergleichssignalausgang des Komparators ausgebbar ist, und eine Auswerteeinrichtung, die mit den Vergleichssignalausgängen der Komparatoren und mit dem Referenzsignalgenerator verbunden ist und mittels derer in Abhängigkeit von den empfangenen Vergleichssignalen für die Analogsignale entsprechende, die Pegel der Analogsignale wiedergebende Digitalsignale bildbar und abgebbar sind.

Der erfindungsgemäße Analog-Digital-Wandler ist insbesondere zur Durchführung des erfindungsgemäßen Verfahrens geeignet.

Das erfindungsgemäße Verfahren und der erfindungsgemäße Analog-Digital-Wandler dienen zur Wandlung von Analogsignalen wenigstens zweier Kanäle, vorzugsweise von mehr als zwei Kanälen, über die Analogsignale, beispielsweise Messdaten in analoger Form, von entsprechenden Analogsignalquellen übertragen werden können.

Die Wandlung von Analogsignalen erfolgt dabei in Zeitintervallen, während derer die Wandlung der Analogsignale, bzw. deren Pegel in entsprechende Digitalsignale bzw. den Pegel wiedergebende digitale Daten erfolgt. Die Dauer des Zeitintervalls, die die Verarbeitungsfrequenz des Verfahrens bzw. des Analog-Digital-Wandlers bestimmt, hängt dabei von den weiteren Details des Verfahrens und insbesondere auch der Verarbeitungsgeschwindigkeit der in dem Analog-Digital-Wandler verwendeten Einrichtungen ab. Die Länge des Zeitintervalls braucht dabei nicht konstant zu sein und kann sich je nach Verfahrensvariante auch in Abhängigkeit davon ändern, wie verschieden voneinander die Pegel der Analogsignale sind.

Das erfindungsgemäße Verfahren und der erfindungsgemäße Analog-Digital-Wandler zeichnen sich dadurch aus, dass ein Referenzsignal mit einem sich zeitlich ändernden Referenzpegel gebildet wird und die Pegel der Analogsignale zu verschiedenen Zeitpunkten in dem Zeitintervall im Wesentlichen parallel mit dem Referenzpegel des Referenzsignals verglichen und für die Analogsignale jeweils entsprechende, das Ergebnis des jeweiligen Vergleichs wiedergebende Vergleichssignale gebildet werden. Bei dem Referenzsignal kann es sich dabei insbesondere um ein Spannungssignal handeln, dessen Pegel sich zeitlich ändert. Die Änderung des Referenzpegels kann dabei entweder zu Beginn des Verfahrens festgelegt sein oder im Verlaufe des Verfahrens, insbesondere in Abhängigkeit von wenigstens einem Vergleichssignal, ermittelt werden. Weiterhin kann sich der Pegel schrittweise oder kontinuierlich ändern. Der erfindungsgemäße Analog-Digital-Wandler verfügt hierzu über den Referenzsignalgenerator, über dessen Referenzsignalausgang das Referenzsignal abgebbar ist.

Zum parallelen Vergleich der Pegel der Analogsignale mit demselben Referenzpegel besitzt der erfindungsgemäße Analog-Digital-Wandler für jeden der Kanäle jeweils einen Komparator, der einen Analogsignaleingang zur Zuführung des Analogsignals des entsprechenden Kanals und einen Referenzsignaleingang aufweist. Die Referenzsignaleingänge der Komparatoren sind dabei parallel mit dem Referenzsignalausgang des Referenzsignalgenerators verbunden, so dass an den Referenzsignaleingängen der Komparatoren im Wesentlichen gleichzeitig jeweils der gleiche Referenzpegel anliegt und die Pegel der Analogsignale im Wesentlichen gleichzeitig bzw. parallel mit demselben Referenzpegel verglichen werden können.

Bei dem erfindungsgemäßen Verfahren erfolgen die Vergleiche zu verschiedenen Zeitpunkten, die so gewählt sind, dass die für das Verfahren notwendigen Vergleiche mit entsprechenden, insbesondere voneinander verschiedenen, vorgegebenen oder während des Verfahrens ermittelten, Referenzpegeln stattfinden. Vorzugsweise erfolgt der Vergleich im Wesentlichen kontinuierlich, d.h. so häufig, wie es die Schaltzeiten der Komparatoren zulassen.

Entsprechend dem Ergebnis des Vergleichs für das jeweilige Analogsignal bzw. den jeweiligen Kanal werden das Ergebnis des Vergleichs wiedergebende Vergleichssignale gebildet, was bei dem erfindungsgemäßen Analog-Digital-Wandler in den Komparatoren erfolgt. Die Vergleichssignale können dann über entsprechende Vergleichssignalausgänge ausgegeben werden.

Für jedes Analogsignal wird dann auf der Basis wenigstens eines der Vergleichssignale für das jeweilige Analogsignal ein dessen Pegel wiedergebendes Digitalsignal gebildet. Bei der Bildung des Digitalsignals bzw. des Digitalwertes, den das Digitalsignal darstellt, können noch weitere Abhängigkeiten berücksichtigt werden. Insbesondere kann der explizit oder durch den Verfahrensablauf implizit gegebene Wert des für die Bildung des jeweiligen Vergleichssignals gesetzten Referenzpegels verwendet werden. Die Digitalsignale geben dabei selbstverständlich die Pegel der Analogsignale nur näherungsweise wieder, wobei die Genauigkeit unter anderem durch die Anzahl der zur Darstellung verwendeten Bits bestimmt ist.

Bei dem erfindungsgemäßen Analog-Digital-Wandler ist hierzu die Auswerteeinrichtung vorgesehen, die mit den Vergleichssignalausgängen der Komparatoren und mit dem Referenzsignalgenerator verbunden ist. Je nach Ausbildung des Analog-Digital-Wandlers kann dabei die Auswerteeinrichtung den Referenzsignalgenerator steuern oder sie kann Signale des Referenzsignalgenerators empfangen, wobei zu den Vergleichssignalen die jeweils bei deren Bildung verwendeten bzw. an den Referenzsignaleingängen anliegenden Referenzpegel wenigstens indirekt bekannt oder ermittelbar sind.

Die gebildeten Digitalsignale können die Werte der Pegel grundsätzlich in beliebiger Codierung wiedergeben. Hierzu braucht nur die Auswerteeinrichtung entsprechend ausgebildet zu sein.

Das erfindungsgemäße Verfahren erlaubt kurze Wandlungszeiten auch bei einer großen Anzahl von Kanälen, erfordert dabei aber nur einen vergleichsweise geringen Schaltungsaufwand. Die hohe Arbeitsgeschwindigkeit ergibt sich daraus, dass Vergleiche für alle Kanäle parallel erfolgen und damit der Referenzpegel zur Bildung jeweils eines digitalen Wertes der Pegel aller Analogsignale bzw. Kanäle jeweils nur einmal auf einen der zu setzenden Werte gesetzt zu werden braucht. Die Vergleichssignale können dann insbesondere auch parallel an die Auswerteeinrichtung übertragen werden, wo sie dann wenigstens teilweise verarbeitet werden können.

Durch die Verwendung nur eines Referenzsignalgenerators ist der Schaltungsaufwand gegenüber der Verwendung einer der Anzahl der Kanäle entsprechenden Anzahl von Analog-Digital-Wandlern erheblich reduziert.

Durch die hohe Verarbeitungsgeschwindigkeit bei nur geringem schaltungstechnischen Aufwand und damit geringen Kosten eignen sich das erfindungsgemäße Verfahren und der erfindungsgemäße Analog-Digital-Wandler sehr gut zum Einsatz in Massenprodukten, insbesondere auch in Fahrzeugen.

Weiterbildungen und bevorzugte Ausführungsformen der Erfindung sind in der Beschreibung, den Zeichnungen und den Ansprüchen beschrieben.

Bei dem erfindungsgemäßen Verfahren ist es vorgesehen, dass in einem ersten Zyklus der Referenzpegel auf einen ersten vorbestimmten Wert gesetzt wird, die Pegel der Analogsignale mit dem Referenzpegel verglichen und für die Analogsignale entsprechende Vergleichssignale gebildet werden, dass in aufeinander folgenden Zyklen für jedes Analogsignal ein in dem Zyklus zu setzender Wert für den Referenzpegel ermittelt wird, der jeweils in Abhängigkeit von der Anzahl der seit dem ersten Zyklus abgearbeiteten Zyklen und von Vergleichsergebnissen für das jeweilige Analogsignal in den vorhergehenden Zyklen oder dem für das jeweilige Analogsignal ermittelten Wert des Referenzpegels im vorhergehenden Zyklus in Verbindung mit dem entsprechenden Vergleichsergebnis für das jeweilige Analogsignal des vorhergehenden Zyklus bestimmt ist, der Referenzpegel in dem Zyklus auf alle voneinander verschiedenen ermittelten, zu setzenden Werte gesetzt wird, und die Pegel der Analogsignale parallel mit dem jeweiligen Referenzpegel verglichen und das Ergebnis des jeweiligen Vergleichs wiedergebende Vergleichssignale gebildet werden, und dass für jedes Analogsignal in Abhängigkeit von, vorzugsweise allen, Vergleichsergebnissen für das jeweilige Analogsignal, die jeweils bei einem für das Analogsignal ermittelten Wert des Referenzpegels bestimmt wurden, oder wenigstens einem der Vergleichsergebnisse für das Analogsignal, die jeweils bei einem für das Analogsignal ermittelten Referenzpegel bestimmt wurden, und wenigstens einem für das Analogsignal ermittelten Wert des Referenzpegels ein den Pegel des Analogsignals wiedergebendes Digitalsignal gebildet wird.

Hierzu ist es bei dem erfindungsgemäßen Analog-Digital-Wandler vorgesehen, dass der Referenzsignalgenerator durch Steuersignale an einem Steuersignaleingang des Referenzsignalgenerators steuerbar ist, und dass die Auswerteeinrichtung eine Steuereinrichtung aufweist, die mit dem Steuersignaleingang verbunden ist und mittels derer der Referenzsignalgenerator so steuerbar ist, dass in einem ersten Zyklus der Referenzpegel auf einen ersten vorbestimmten Wert gesetzt wird, und dass in aufeinander folgenden Zyklen für jedes Analogsignal ein in dem Zyklus zu setzender Wert für den Referenzpegel ermittelt wird, der jeweils in Abhängigkeit von der Anzahl der seit dem ersten Zyklus abgearbeiteten Zyklen und von Vergleichsergebnissen für das jeweilige Analogsignal in den vorhergehenden Zyklen oder dem für das jeweilige Analogsignal ermittelten zu setzenden Wert des Referenzpegels im vorhergehenden Zyklus in Verbindung mit dem entsprechenden Vergleichsergebnis für das jeweilige Analogsignal des vorhergehenden Zyklus bestimmt ist, und der Referenzpegel in dem Zyklus auf alle voneinander verschiedenen ermittelten, zu setzenden Werte gesetzt wird, und dass die Auswerteeinrichtung weiter so ausgebildet ist, dass für jedes Analogsignal in Abhängigkeit von, vorzugsweise allen, Vergleichsergebnissen für das jeweilige Analogsignal, die jeweils bei einem für das Analogsignal ermittelten Wert des Referenzpegels bestimmt wurden, oder wenigstens einem der Vergleichsergebnisse für das Analogsignal, die jeweils bei einem für das Analogsignal ermittelten Referenzpegel bestimmt wurden, und wenigstens einem für das Analogsignal ermittelten Wert des Referenzpegels Daten ermittelbar sind, die den Pegel des Analogsignals wiedergeben.

Vorzugsweise wird bei Verwendung eines ermittelten Referenzpegels zur Bildung des Digitalsignals bzw. zur Ermittlung der Daten das bei diesem Referenzpegel ermittelte Vergleichsergebnis verwendet. Besonders bevorzugt handelt sich um den entsprechenden Referenzpegel und das entsprechende Vergleichssignal in dem letzten Zyklus zur Bestimmung des Digitalwertes bzw. zur Bildung des Digitalsignals.

Bei dem erfindungsgemäßen Verfahren erfolgt die Analog-Digital-Wandlung also in mehreren Zyklen, wobei die Anzahl der Zyklen insbesondere durch eine vorgegebene Anzahl von Bits vorgegeben sein kann, durch die die Pegel der Analogsignale in dem Digitalsignal darstellbar sind. Ausgehend von einem Vergleichsergebnis im ersten Zyklus bei einem vorgegebenen ersten Wert des Referenzpegels werden in den folgenden Zyklen jeweils für jedes Analogsignal zu setzende Werte für den Referenzpegel ermittelt. Unter der Ermittlung eines Wertes für den Referenzpegel wird dabei auch verstanden, dass nicht der Wert des Referenzpegels selbst, sondern ein Wert für ein Steuersignal ermittelt wird, das zur Bildung des Referenzsignals verwendet wird. Die Ermittlung des Wertes des Referenzpegels kann einmal in Abhängigkeit von allen bisher in den vorhergehenden Zyklen ermittelten Vergleichsergebnissen erfolgen, die gleichzeitig die Werte der entsprechenden Referenzpegel implizieren. Zum anderen kann dies auch in Abhängigkeit von dem für das jeweilige Analogsignal ermittelten zu setzenden Wert des Referenzpegels im vorhergehenden Zyklus in Verbindung mit dem entsprechenden Vergleichsergebnis für das jeweilige Analogsignal des vorhergehenden Zyklus erfolgen. Weiterhin hängt bei beiden Varianten der zu setzende Wert für den Referenzpegel zusätzlich von der Anzahl der seit dem ersten Zyklus abgearbeiteten Zyklen und gegebenenfalls auch der Gesamtanzahl der möglichen Zyklen bzw. der Anzahl der Bits des resultierenden Digitalsignals ab.

Um eine möglichst schnelle Ausführung der Wandlung zu erzielen, wird der Referenzpegel in jedem Zyklus auf alle voneinander verschiedenen ermittelten, zu setzenden Werte gesetzt. Vorzugsweise wird der Referenzpegel nur auf diese Werte gesetzt. Das bedeutet, dass beispielsweise in dem Fall, dass Gruppen von Analogsignalen auftreten, für die in den vorhergehenden Zyklen gleiche Vergleichsergebnisse ermittelt wurden bzw. für die in dem vorhergehenden Zyklus gleiche zu setzende Werte des Referenzpegels ermittelt wurden und die bei dem entsprechenden Vergleich die gleichen Vergleichsergebnisse aufgewiesen haben, für diese Gruppen der Referenzpegel nur einmal auf den entsprechenden Wert gesetzt zu werden braucht. Dadurch werden die Anzahl der gegebenenfalls notwendigen Änderungen des Referenzpegels und die Anzahl der notwendigen Vergleiche deutlich herabgesetzt.

Zur Ermittlung der Referenzpegel ist die Auswerteeinrichtung des erfindungsgemäßen Analog-Digital-Wandlers entsprechend ausgebildet und weist die Steuereinrichtung auf, die gemäß der ersten Verfahrensvariante den zu setzenden Referenzpegeln entsprechende Daten bzw. Signale bildet und den Referenzsignalgenerator dann entsprechend ansteuert.

Bei einer Weiterbildung dieser Verfahrensvariante ist es bevorzugt, dass die Pegel der Analogsignale durch eine vorgegebene Anzahl von Bits dargestellt werden, und dass der erste Wert des Referenzpegels einem durch das höchstwertige Bit dargestellten Pegel entspricht. Bei dem erfindungsgemäßen Analog-Digital-Wandler ist es dementsprechend bevorzugt, dass die Auswerteeinrichtung so ausgebildet ist, dass die Pegel der Analogsignale durch eine vorgegebene Anzahl von Bits dargestellt werden, und dass die Steuereinrichtung so ausgebildet ist, dass der erste Wert des Referenzpegels einem durch das höchstwertige Bit dargestellten Pegel entspricht.

Es ist dann weiterhin bei dem erfindungsgemäßen Verfahren bevorzugt, dass der zu setzende Wert des Referenzpegels für ein Analogsignal in einem Zyklus n gegenüber dem entsprechenden, in dem vorhergehenden Zyklus ermittelten, zu setzenden Wert des Referenzpegels für das Analogsignal um den Wert des Referenzpegels im ersten Zyklus dividiert durch $2^{n-1}$ reduziert ist, wenn im vorhergehenden Zyklus der Pegel des Analogsignals kleiner als der Referenzpegel war, während dieser auf den für das Analogsignal als zu setzend ermittelten Wert gesetzt war, und um den Wert des Referenzpegels im ersten Zyklus dividiert durch $2^{n-1}$ erhöht ist, wenn im vorhergehenden Zyklus der Pegel des Analogsignals größer als der Referenzpegel war, während dieser auf den für das Analogsignal als zusetzend ermittelten Wert gesetzt war, wobei n die Ordinalzahl des Zyklus bezeichnet. n ist dabei größer als 1.

Bei dem erfindungsgemäßen Analog-Digital-Wandler ist es dazu bevorzugt, dass die Steuereinrichtung so ausgebildet ist, dass der zu setzende Wert des Referenzpegels für ein Analogsignal in einem Zyklus n gegenüber dem entsprechenden, in dem vorhergehenden Zyklus ermittelten, zu setzenden Wert des Referenzpegels für das Analogsignal um den Wert des Referenzpegels im ersten Zyklus dividiert durch $2^{n-1}$ reduziert ist, wenn im vorhergehenden Zyklus der Pegel des Analogsignals kleiner als der Referenzpegel war, während dieser auf den für das Analogsignal als zu setzend ermittelten Wert gesetzt war, und um den Wert des Referenzpegels im ersten Zyklus dividiert durch $2^{n-1}$ erhöht ist, wenn im vorhergehenden Zyklus der Pegel des Analogsignals größer als der Referenzpegel war, während dieser auf den für das Analogsignal als zu setzend ermittelten Wert gesetzt war, wobei n die Ordinalzahl des Zyklus bezeichnet.

Bei dieser Variante des erfindungsgemäßen Verfahrens bzw. des erfindungsgemäßen Analog-Digital-Wandlers wird also für ein gegebenes Analogsignal sukzessive der Referenzpegel verändert, wobei eine Erhöhung bzw. Erniedrigung des Referenzpegels erfolgt, wenn der Pegel des Analogsignals größer bzw. kleiner als der entsprechende Referenzpegel in dem vorhergehenden Zyklus war. Durch den Betrag der Änderung, der für den n-ten Zyklus durch den Referenzpegel in dem ersten Zyklus dividiert durch $2^{n-1}$ gegeben ist, ergibt sich eine schnelle und einfache bitweise Darstellung des Pegels des Analogsignals. Für den Fall, dass das Verfahren nur für einen Kanal ausgeführt würde, ergäbe sich als Grenzfall das so genannte Wägeverfahren zur Analog-Digital-Wandlung.

Zur Ermittlung der Digitalsignale bzw. entsprechender Digitalwerte ist es dann bevorzugt, dass am Ende des letzten Zyklus N für ein Analogsignal ein Digitalsignal gebildet wird, das einem Digitalwert entspricht, der den für dieses im letzten Zyklus ermittelten Referenzpegel vermindert um einen dem niedrigstwertigen Bit entsprechenden Pegel wiedergibt, wenn das bei dem Vergleich der Pegel des Analogsignals kleiner als der für es ermittelte Referenzpegel war, und das einem Digitalwert entspricht, der dem für dieses Analogsignal im letzten Zyklus ermittelten Referenzpegel wiedergibt, wenn der Pegel des Analogsignals größer als der Referenzpegel ist. Bei dem erfindungsgemäßen Analog-Digital-Wandler ist es dazu bevorzugt, dass die Auswerteeinrichtung so ausgebildet ist, dass am Ende des letzten Zyklus N für ein Analogsignal ein Digitalsignal bildbar ist, das einem Digitalwert entspricht, der den für dieses im letzten Zyklus ermittelten Referenzpegel vermindert um einen dem niedrigstwertigen Bit entsprechenden Pegel wiedergibt, wenn das bei dem Vergleich der Pegel des Analogsignals kleiner als der für dieses Analogsignal ermittelte Referenzpegel war, und das einem Digitalwert entspricht, der dem für dieses Analogsignal im letzten Zyklus ermittelten Referenzpegel wiedergibt, wenn der Pegel des Analogsignals größer als der Referenzpegel ist. Insbesondere kann bei Verwendung eines Digital-Analog-Wandlers in dem Referenzsignalgenerator als Digitalwert der jeweilige, dem Referenzpegel entsprechende Steuersignalwert reduziert um 1 bzw. der Steuersignalwert verwendet werden.

Bei einem anderen Verfahren ist es bevorzugt, dass der Referenzpegel als vorgegebene Funktion der Zeit zyklisch verändert wird, und dass bei einer Änderung des Vergleichsergebnisses für ein Analogsignal während eines Zyklus der Zeitpunkt der Änderung erfasst und in Abhängigkeit von der Lage des Zeitpunkts in dem Zyklus das Digitalsignal gebildet wird. Bei dem anderen Analog-Digital-Wandler ist es dazu bevorzugt, dass der Referenzsignalgenerator zur Bildung eines Referenzsignals mit einem Referenzpegel ausgebildet ist, der sich als vorgegebene Funktion der Zeit zyklisch ändert, dass der Referenzsignalausgang mit einem Referenzsignaleingang der Auswerteeinrichtung verbunden ist, und dass die Auswerteeinrichtung eine Einrichtung zur Ermittlung des Referenzpegels in Abhängigkeit von empfangenen Vergleichssignalen aufweist. Insbesondere kann die Auswerteeinrichtung eine Einrichtung aufweisen, mittels derer ein Zeitabstand zwischen einer Veränderung eines Vergleichssignals und dem Beginn eines Zyklus ermittelbar ist. Mit dieser Variante ergibt sich ein besonders einfacher Analog-Digital-Wandler, da die zur Auswertung der Vergleichssignale notwendige Logik sehr einfach ausgebildet sein kann.

Bei einem zweiten anderen Verfahren ist es bevorzugt, dass in aufeinander folgenden Zyklen der Referenzpegel jeweils als vorgegebene Funktion der Zeit schrittweise verändert wird, und dass bei einer Änderung des Vergleichsergebnisses für ein Analogsignal auf der Basis der Anzahl der Änderungsschritte in einem aktuellen Zyklus das entsprechende Digitalsignal gebildet wird. Bei dem zweiten anderen Analog-Digital-Wandler ist es dazu bevorzugt, dass die Auswerteeinrichtung eine Steuereinrichtung aufweist, mittels derer Steuersignale an den Referenzsignalgenarator ausgebbar sind, so dass der Referenzpegel des Referenzsignals in aufeinander folgenden Zyklen jeweils als vorgegebene Funktion der Zeit schrittweise verändert wird, und dass die Auswerteeinrichtung so ausgebildet ist, dass bei einer Änderung des Vergleichsergebnisses für ein Analogsignal auf der Basis der Anzahl der Änderungsschritte in einem aktuellen Zyklus das entsprechende Digitalsignal gebildet wird. Die Größe der Schritte kann dabei in Abhängigkeit von der gewünschten Auflösung der Analog-Digital-Wandlung gewählt sein. Da bei diesem Verfahren eine Steuerung des Referenzsignalgenerators durch die Auswerteeinrichtung bzw. die Steuereinrichtung darin erfolgt, ist eine sehr einfache Erfassung des bei einem Vergleich verwendeten Referenzpegels möglich, bei dem insbesondere eine Zeitmessung vermieden werden kann.

Das Referenzsignal kann grundsätzlich auf verschiedene Arten und Weisen gebildet werden. Insbesondere bei dem anderen Verfahren kann eine analoge Schaltung, beispielsweise ein Sägezahngenerator zur Erzeugung des Referenzsignals verwendet werden. Insbesondere bei dem erfindungsgemäßen Verfahren ist es jedoch bevorzugt, dass die Referenzsignale durch eine Digital-Analog-Wandlung gebildet werden. Bei dem erfindungsgemäßen Analog-Digital-Wandler ist es dazu bevorzugt, dass der Referenzsignalgenerator einen Digital-Analog-Wandler umfasst, dessen Ausgang mit dem Referenzsignalausgang verbunden ist. Auf diese Weise kann der Wert des Referenzpegels sehr einfach festgelegt werden, indem in der Auswerteeinrichtung bzw. deren Steuereinrichtung ein entsprechender digitaler Wert berechnet wird, der dann durch den Digital-Analog-Wandler in ein entsprechendes Referenzsignal mit einem gewünschten Referenzpegel umgesetzt wird.

Bei einem zweiten anderen Analog-Digital-Wandler, der zur Durchführung des zweiten anderen Verfahrens ausgebildet ist, ist es insbesondere bevorzugt, dass die Steuereinrichtung einen Zähler aufweist, mittels dessen der Digital-Analog-Wandler ansteuerbar ist, und dass die Auswerteeinrichtung eine Erfassungseinrichtung aufweist, mittels derer bei Änderung eines Vergleichssignals der Wert des Zählers erfassbar ist. Die Änderung des Vergleichssignals zeigt dabei eine Änderung des Vergleichsergebnisses für das jeweilige Analogsignal an. Auf diese Weise kann die Auswerteeinrichtung einschließlich der Steuereinrichtung vollständig als digitale Schaltung ausgebildet werden.

Insbesondere wenn das erfindungsgemäße Verfahren für im Vergleich mit der Erfassungs- bzw. Wandlungsfrequenz bzw. der Länge des für die Analog-Digital-Wandlung notwendigen Zeitintervalls sich zeitlich schnell ändernde Analogsignale verwendet werden soll, ist es bevorzugt, dass der Pegel wenigstens eines der Analogsignale während der Dauer der Bildung jeweils eines Digitalwerts für alle Kanäle im Wesentlichen konstant gehalten wird. Dazu ist es dann bei dem erfindungsgemäßen Analog-Digital-Wandler bevorzugt, dass wenigstens eine vor den Analogsignaleingang wenigstens eines der Komparatoren geschaltete Erfassungs- und Halteschaltung vorgesehen ist. Die Erfassungs- und Halteschaltung ist dabei vorzugsweise so ausgebildet, dass ein ihr zugeführtes analoges Signal erfasst wird, und ein entsprechendes Analogsignal mit für die Dauer der Bildung jeweils eines Digitalwerts für alle Kanäle konstantem Pegel abgegeben wird. Vorzugsweise kann die Auswerteeinrichtung so ausgebildet sein, dass nach der Bildung der Digitalwerte ein Triggersignal an die Erfassungs- und Halteschaltung ausgebbar ist, auf das hin in dieser eine erneute Erfassung des Pegels erfolgt. Dies ermöglicht insbesondere bei variierenden Zeitdauern für die Bestimmung der Digitalsignale, beispielsweise bei der ersten Variante, ein hohe Erfassungs- bzw. Wandlungsrate.

Die Erfindung wird nun weiter beispielhaft anhand der Zeichnungen erläutert. Es zeigen:

Fig. 1 ein schematisches Blockschaltbild eines erfindungsgemäßen Analog-Digital-Wandlers mit mehreren damit verbundenen Analogsignalquellen,

Fig. 2 ein schematisches Diagramm zur Erläuterung des von dem Analog-Digital-Wandler in Fig. 1 verwendeten Verfahrens für den Fall von vier Kanälen und einer Darstellung der Pegel von Analogsignalen der Kanäle durch drei Bits,

Fig. 3 ein schematisches Blockschaltbild eines anderen Analog-Digital-Wandlers, und

Fig. 4 ein schematisches Blockschaltbild eines zweiten anderen Analog-Digital-Wandlers.

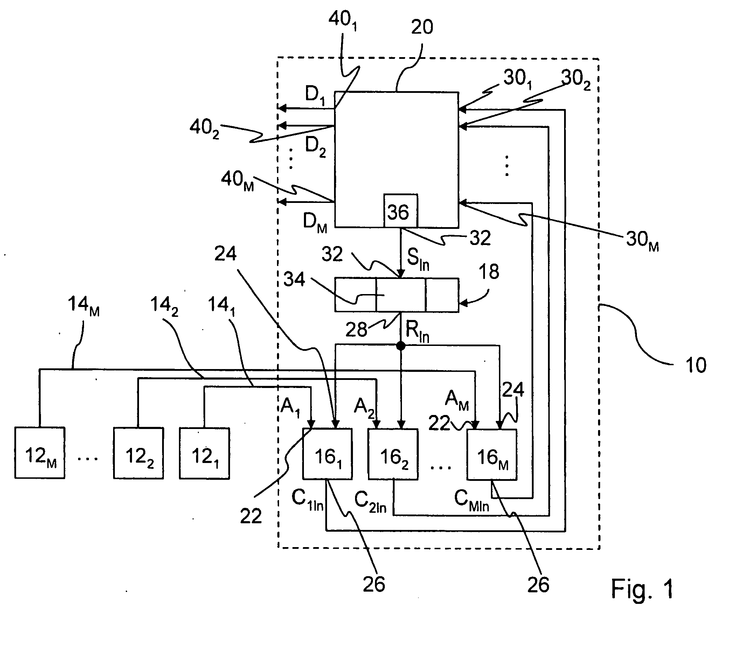

In Fig. 1 ist ein Analog-Digital-Wandler 10 nach einer ersten bevorzugten Ausführungsform der Erfindung mit M nur teilweise gezeigten Analogsignalquellen $12_1, ... 12_M$, bei denen es sich beispielsweise um Sensoren in einem Kraftfahrzeug handeln kann, über nur schematisch gezeigte Kanäle $14_1, ... 14_M$ verbunden. Dabei bezeichnet M eine natürliche Zahl größer als 1.

Der Analog-Digital-Wandler 10 verfügt über eine der Anzahl der Kanäle $14, ... 14_M$ entsprechende Anzahl M von gleich ausgebildete Komparatoren $16_1, ... 16_M$, einen Referenzsignalgenerator 18 und eine Auswerteeinrichtung 20.

Jeder der Komparatoren $16_1, ... 16_M$ ist einem der Kanäle $14, ... 14_M$ zugeordnet und weist einen mit der jeweiligen Analogsignalquelle verbundenen Analogsignaleingang 22, einen Referenzsignaleingang 24 und einen Vergleichssignalausgang 26 auf, über den jeweils ein Vergleichssignal ausgebbar ist, das das Ergebnis des Vergleichs der Pegel, im Beispiel Spannungspegel, des an dem Analogsignaleingang 22 und dem Referenzsignaleingang 24 anliegenden Analog- bzw. Referenzsignals wiedergibt. Zur einfacheren Darstellung werden diese Ein- und Ausgänge für alle Komparatoren mit dem gleichen Bezugszeichen gekennzeichnet.

Die Komparatoren $16_1$, ... $16_M$ sind mit ihren Referenzsignaleingängen 24 parallel mit einem Referenzsignalausgang 28 des Referenzsignalgenerators 18 verbunden.

Zur parallelen Übertragung der Vergleichssignale der Komparatoren $16_1$, ... $16_M$ an die Auswerteeinrichtung 20 sind die Vergleichssignalausgänge 26 mit entsprechenden Vergleichssignaleingängen $30_1$, ..., $30_M$ der Auswerteeinrichtung 20 über entsprechende Verbindungen verbunden.

Der Referenzsignalgenerator 18 verfügt über einen Steuersignaleingang 32, über den dem Referenzsignalgenerator 18 Steuersignale zuführbar sind, mittels derer ein von dem Referenzsignalgenerator 18 erzeugtes Referenzsignal bzw. dessen Referenzpegel steuerbar ist, das dann über den Referenzsignalausgang 28 an die Komparatoren $16_1$, ... $16_M$, bzw. deren Referenzsignaleingänge 24 parallel abgegeben wird. Im Beispiel weist der Referenzsignalgenerator 18 dazu einen mit dem Steuersignaleingang 32 verbundenen Digital-Analog-Wandler 34 auf, mittels dessen in Abhängigkeit von über den Steuersignaleingang 32 zugeführten digitalen Steuersignalen entsprechende analoge Referenzsignale mit durch die Steuersignale bestimmten Referenzpegeln, im Beispiel Spannungspegeln, bildbar und abgebbar sind.

Die Auswerteeinrichtung 20 verfügt über eine Auswertelogik zur Auswertung der von den Komparatoren empfangenen Vergleichssignale sowie eine Steuereinrichtung 36 zur Bildung von digitalen Steuersignalen und Abgabe der Steuersignale über einen Steuersignalausgang 38 an den Referenzsignalgenerator 18, im Beispiel insbesondere den Digital-Analog-Wandler 34.

Die Auswertelogik und die Steuereinrichtung 36 sind so ausgebildet, dass die Vergleichsignale entsprechend einem im Folgenden zu beschreibenden Verfahren zur Analog-Digital-Wandlung nach einer bevorzugten Ausführungsform der Erfindung verarbeitet und Steuersignale entsprechend diesem Verfahren gebildet werden können. Eine entsprechende detaillierte Schaltung kann auf der Basis des Verfahrens und des Blockschaltbildes beispielsweise mit Hilfe von dem Fachmann bekannten Programmen wie z.B. dem Programm "Synopsys" (Synopsys, Inc., Mountain View, CA, USA) erhalten werden.

Die Auswerteeinrichtung 20 gibt von ihr mittels der Auswertelogik für die Kanäle 14, ... $14_M$ bzw. die Analogsignale dieser Kanäle gebildete Digitalsignale, die die Pegel der Analogsignale näherungsweise wiedergeben, über entsprechende Digitalsignalausgänge $40_1$, ... $40_M$ aus.

Bei dem Verfahren zur Analog-Digital-Wandlung nach einer bevorzugten Ausführungsform der Erfindung werden Analogsignale auf den M Kanälen in M entsprechende Digitalsignale umgewandelt, die die Pegel der Analogsignale näherungsweise mit einer vorgegebenen Anzahl N von Bits wiedergeben. N ist dabei eine natürliche Zahl größer als 1. Im Folgenden werden Pegel von Signalen oder durch Signale dargestellte Werte der Einfachheit halber mit den gleichen Formelzeichen bezeichnet wie die Signale selbst.

Um für jedes von den Analogsignalquellen $12_1$, ... $12_M$ abgegebene Analogsignal $A_1$, ... $A_M$ jeweils einen den Pegel des jeweiligen Analogsignals darstellenden Digitalwert bzw. ein entsprechendes Digitalsignal $D_1$, ... $D_M$ bilden zu können, werden jeweils N Zyklen abgearbeitet, im Verlauf derer die Digitalsignale für alle Kanäle bzw. Analogsignale $A_1$, ... $A_M$ gebildet bzw. entsprechende die Pegel der Analogsignale darstellende Digitalwerte ermittelt werden.

Dabei wird ein Referenzsignal mit einem zeitabhängigen Referenzpegel gebildet, dessen Zeitverlauf in Abhängigkeit von den Pegeln der Analogsignale bestimmt wird. Im Beispiel wird in einem Zyklus n ein Referenzsignal mit wenigstens einem entsprechenden Referenzpegel gebildet. Dieses ist in Fig. 1 mit $R_{1n}$ bezeichnet, wobei n die Ordinalzahl des Zyklus ist, die daher Werte von 1 bis N annehmen kann. Der Index 1 bezeichnet dabei, wie auch im Folgenden, eine natürliche Zahl, die, je nach Verfahrensverlauf, Werte zwischen 1 und der Anzahl der in dem Zyklus n zu setzenden, voneinander verschiedenen Referenzpegel annehmen kann.

Die Referenzpegel $R_{1n}$ des Referenzsignals werden dann jeweils im Wesentlichen parallel mit den Pegeln der Analogsignale $A_j$, j=1, ... ,M verglichen und es werden entsprechende, das Ergebnis des jeweiligen Vergleichs wiedergebende Vergleichssignale $C_{jln}$ gebildet, was bei Verwendung des Analog-Digitalwandlers 10 in dem Komparatoren $16_1$, ...$16_M$ erfolgt Der Index j bezeichnet dabei hier wie auch im Folgenden das entsprechende Analogsignal bzw. den einen entsprechenden Kanal und kann daher ganzzahlige Werte zwischen 1 und M annehmen.

Die Vergleichssignale $C_{1ln}$, ... $C_{Mln}$ werden im Wesentlichen parallel an die Auswerteeinrichtung 20 übertragen, wo sie, je nach Zyklus, zur Ermittlung von Referenzpegeln im nächsten Zyklus oder zur Ermittlung der Digitalsignale verwendet werden können.

Genauer wird in jedem Zyklus für jedes Analogsignal $A_j$ ein neuer zu setzender Wert für den Referenzpegel des Referenzsignals ermittelt, der in dem aktuellen Zyklus zum Vergleich mit dem Pegel des Analogsignals $A_j$ zu verwenden ist.

Der zu setzende Wert für das Analogsignal $A_j$ wird in Abhängigkeit von der Anzahl der bereits abgearbeiteten Zyklen, d.h. der Zahl n, der Anzahl der Bits N bzw. dem Referenzpegel im ersten Zyklus, dem Referenzpegel für das Analogsignal in dem vorhergehenden Zyklus und dem bei diesem ermittelten Vergleichsergebnis bzw. Vergleichssignal ermittelt. Aus der so erhaltenen Menge von zu setzenden Referenzpegeln werden während eines Zyklus gleiche Referenzpegel nur einmal gesetzt, was durch den parallelen Vergleich der Analogsignalpegel mit den Referenzpegeln ermöglicht wird. Es werden also innerhalb eines Zyklus nur alle voneinander verschiedenen Referenzpegel aus der Menge der ermittelten, zu setzenden Referenzpegel tatsächlich gesetzt, was bei einer großen Zahl M von Kanälen oder Analogsignalen mit sehr ähnlichen Pegeln zu einer wesentlichen Beschleunigung des Verfahrens führt, da innerhalb eines Zyklus der Referenzpegel nicht für jeden Kanal neu gesetzt zu werden braucht. Die tatsächlich in einem Zyklus gesetzten Referenzpegel und die entsprechenden Vergleichssignale werden durch den zuvor erwähnten Index 1 unterschieden.

Im Ausführungsbeispiel werden die Referenzpegel dadurch ermittelt bzw. gesetzt, dass in der Steuereinrichtung 36 für den aktuellen Zyklus n Werte für entsprechende Steuersignale ermittelt bzw. entsprechende Steuersignale $S_{1n}$ gebildet werden.

In Abhängigkeit von den Vergleichssignalen $C_{jln}$ für die Kanäle j in den N Zyklen bzw. der durch diese bestimmten Referenzpegel im letzten Zyklus N und entsprechenden Vergleichssignalen werden dann die Digitalwerte $D_j$ für die Pegel der Analogsignale $A_j$, gebildet. Dies geschieht in der Auswerteeinrichtung 20. Dabei werden für ein Analogsignal $A_j$ nur solche Vergleichssignale $C_{jln}$ berücksichtigt, die bei Verwendung des für das Analogsignal $A_j$ als zu setzend ermittelten Referenzpegels gebildet wurden.

Im Detail läuft das Verfahren folgendermaßen ab:

In dem ersten Zyklus (n=1) wird von der Steuereinrichtung 36 das Steuersignal $S_{11}$ auf den Digitalwert gesetzt, der dem höchstwertigen Bit in der Darstellung der Digitalsignale $D_1$, ... $D_M$ entspricht, d.h. $2^{N-1}$. Der Digital-Analog-Wandler 34 erzeugt ein Referenzsignal $R_{11}$ mit einem entsprechenden Pegel.

Dann werden die Pegel der Analogsignale $A_1$,...$A_M$ mit dem Referenzpegel verglichen und es werden Vergleichssignale $C_{111}$, ... $C_{M11}$ gebildet, die das Vergleichsergebnis wiedergeben. Beispielsweise können diese den binären Wert 0b wiedergeben, wenn der Analogsignalpegel kleiner ist als der Referenzpegel, und 1b, wenn er größer ist.

In den folgenden Zyklen werden in einem aktuellen Zyklus n mit n> 1 für die Analogsignale in Abhängigkeit von dem für ein jeweiliges Analogsignal $A_j$ ermittelten Referenzsignal bzw. -pegel $R_{ln-1}$ bzw. dem entsprechenden Steuersignal $S_{ln-1}$ in dem vorhergehenden Zyklus n-1, dem unter Verwendung dieses Referenzpegels gebildeten entsprechenden Vergleichssignal $C_{jln-1}$ für das jeweilige Analogsignal $A_j$ in dem jeweils vorhergehenden Zyklus n-1 und von der Ordinalzahl n aktuelle zu setzende Referenzpegel ermittelt.

Im Beispiel wird der zu setzende. Referenzpegel im Zyklus n für ein Analogsignal $A_j$ durch Angabe eines zu setzenden Steuersignals $S'_{jn}$ bzw. von dessen digitalem Wert folgendermaßen festgelegt:

War der Pegel für das Analogsignal $A_j$ im letzten Zyklus kleiner als der für das Analogsignal $A_j$ als zu setzend ermittelte Referenzpegel (und hatte das Vergleichssignal daher im Beispiel den Wert Ob), wird der zu setzende Referenzpegel gegenüber dem zur das Analogsignal $A_j$ in dem vorhergehenden Beispiel als zu setzend ermittelten Wert um eine Differenzbetrag herabgesetzt, der sich aus dem Referenzpegel $R_{11}$ im ersten Zyklus dividiert durch $2^{n-1}$ ergibt. Der für das Analogsignal $A_j$ zu setzende Wert des Steuersignals $S'_{j,n}$ ergibt sich daher aus dem für das Analogsignal gesetzten Steuersignal $S_{L(j),n-1}$ des vorhergehenden Zyklus durch Subtraktion von $2^{N-n}$. L(j) bezeichnet dabei den Index 1 für das tatsächlich gesetzte Steuersignal $S_{L(j)n-1}$ im Zyklus n-1, dessen Wert mit dem für das Analogsignal $A_j$ zu setzenden Wert übereinstimmt: $S'_{jn-1}=S_{L(j)n-1}$.

Ergibt der Vergleich das umgekehrte Resultat, d.h. ist der Analogsignalpegel größer als der entsprechende Referenzsignalpegel, wird der entsprechende zu setzende Referenzpegel aus dem vorhergehenden Zyklus nicht um den Differenzbetrag erniedrigt, sondern erhöht.

Es ergeben sich daher folgende Beziehung zur Ermittlung des Wertes des für ein Analogsignal $A_j$ zu setzenden Referenzpegels, gegeben durch den für das Analogsignal zu setzenden Wert $S'_{jn}$ des Steuersignals im Zyklus n:

$$S'_{jn} = 2^N / 2 \qquad\qquad f.\ n = 1,\ j = 1\ bis\ M$$

$$S'_{jn} = S'_{jn-1} + 2^N / 2^n \qquad\qquad f.\ n = 2, 3 \ldots N,\ falls\ C_{j,n-1} = 1b,$$

$$S'_{jn} = S'_{jn-1} - 2^N / 2^n \qquad\qquad f.\ n = 2, 3 \ldots N,\ falls\ C_{j,n-1} = 0b.$$

EP 1 530 295 B1

Tatsächlich gesetzt werden aber nur die voneinander verschiedenen Werte $S_{1n}$, die sich aus den als zu setzend ermittelten Werten $S'_{1n}$, ... $S'_{Mn}$ ergeben.

Am Ende des letzten Zyklus wird der Digitalwert $D_j$ für den Pegel des Analogsignals $A_j$ dadurch bestimmt, dass in dem Fall, dass der Pegel des Analogsignals $A_j$ kleiner als der für dieses im aktuellen, letzten Zyklus ermittelte und gesetzte Referenzpegel $R_{L(j)N}$ ist, der Digitalwert auf den Wert des entsprechenden Steuersignals vermindert um die Zahl 1 gesetzt wird. Andernfalls ist der Digitalwert $D_j$ durch den verwendeten Wert des entsprechenden Steuersignals gegeben. Die entsprechenden Beziehungen lauten daher:

$$D_j = S'_{jN} \qquad \text{falls } C_{jL(j)N} = 1b$$

$$D_j = S'_{jN} - 1 \quad \text{falls } C_{jL(j)N} = 0b.$$

$S'_{jN}-1$ entspricht dabei dem letzten für das Analogsignal $A_j$ gesetzten Referenzpegel im Zyklus N vermindert um einen dem niedrigstwertigen Bit entsprechenden Pegel.

Das Verfahren beginnt nun zur Wandlung neuer Pegel der Analogsignale mit dem ersten Zyklus von vorn.

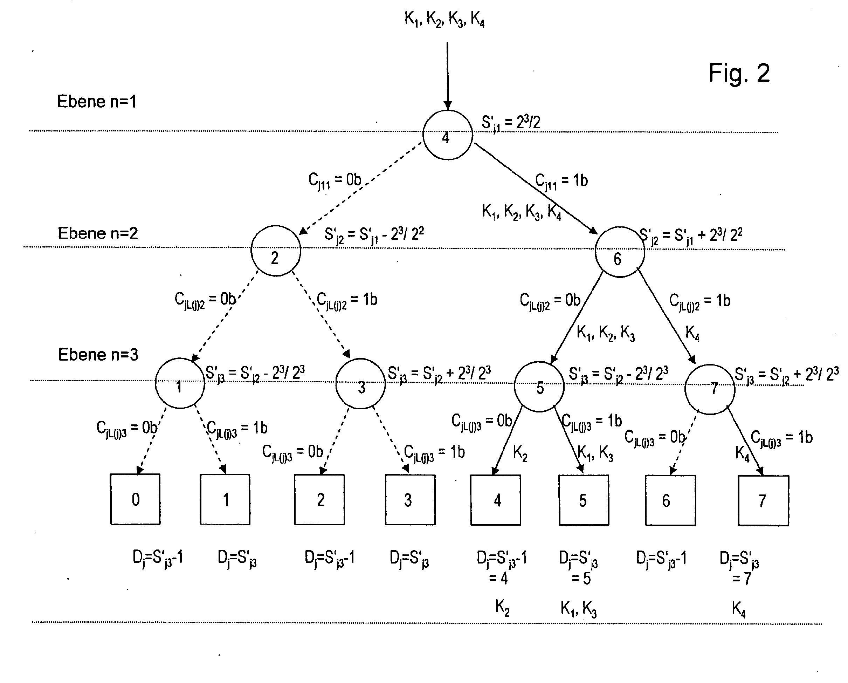

Das Verfahren kann teilweise, nämlich für ein Analogsignal $A_j$, als das Durchlaufen eines Baums (vgl. Fig. 2) dargestellt werden, der in N jeweils einem Zyklus entsprechenden Ebenen jeweils Knoten aufweist, die möglichen zu setzenden Werten des Steuersignals und entsprechenden Vergleichen entsprechen. Die Verzweigung in Zweige unterhalb der Knoten erfolgt entsprechend den Vergleichsergebnissen, so dass in der dem Zyklus n entsprechenden Ebene n $2^{n-1}$ Knoten vorhanden sind.

In Fig. 2 ist dies am Beispiel einer Analog-Digital-Wandlung für M=4 Kanäle und eine Auflösung der Analog-Digital-Wandlung von $2^3$, d.h. eine Darstellung der Pegel durch N=3 Bit, gezeigt. Der dort dargestellte Baum zeigt zum einen alle möglichen Verfahrensverläufe für ein Analogsignal $A_j$. Zum anderen sind konkrete Verläufe für beispielhaft vorgegebene Pegel der Analogsignale bzw. Kanäle gezeigt.

Der Einfachheit halber wird der zu setzende Referenzpegel durch Angabe der Werte des entsprechenden zu setzenden Steuersignals $S'_{jn}$ angegeben. Die Zahl in den Knoten gibt jeweils den dem zu setzenden Referenzpegel entsprechenden zu setzenden Steuersignalwert an, der als Formel jeweils nochmals rechts des Knotens angegeben ist.

Die Kanäle bzw. die entsprechenden Analogsignale sind durch die Bezugszeichen $K_1$, ... $K_4$ bezeichnet.

Die Pfeile entsprechen jeweils der Bewegung in dem Baum entsprechend den Vergleichsergebnissen, wobei gestrichelte Pfeile in dem Beispiel in Fig. 2 theoretisch mögliche Pfade bezeichnen, die jedoch in dem konkreten Beispiel bei den verwendeten Analogsignalpegeln nicht durchlaufen werden. Durchgezogene Pfeile entsprechen Pfaden für die im Beispiel in Fig. 2 angenommenen Pegel der Analogsignale der Kanäle $K_1$, ... $K_4$.

In der ersten Ebene n=1, entsprechend dem ersten Zyklus, wird für alle Kanäle bzw. Analogsignale der einzig mögliche Referenzpegel, nämlich der dem höchstwertigen Bit entsprechende Pegel ermittelt und gesetzt. Der Index 1 nimmt daher als einzigen Wert den Wert 1 an. Zum Setzen des Referenzpegels wird das Steuersignals $S_{l1} = 2^N/2 = S'_{j1}$ gesetzt.

Entsprechend den beiden möglichen Vergleichsergebnissen weist die zweite Ebene zwei Knoten auf.

Im Beispiel ergibt der Vergleich für alle Kanäle $K_1$, ... $K_4$, dass die Pegel der Analogsignale größer sind, als der dem Steuersignalwert $2^{N-1}$ entsprechenden Referenzpegel $R_{11}$, so dass für alle Kanäle die Vergleichssignale $C_{j11}$ den digitalen Wert 1b wiedergeben (j=1,... 4), was durch den durchgezogenen Pfeil zu dem zweiten Knoten in der zweiten Ebene (n=2) und die Angabe der Kanäle gekennzeichnet ist.

Die zwei Knoten in der zweiten Ebene, die dem zweiten Zyklus entspricht, entsprechen möglichen zu setzenden Referenzpegeln bzw. Steuersignalwerten $S'_{j2}$, die sich aus dem Referenzpegel bzw. Steuersignalwert der ersten Ebene in Abhängigkeit von den möglichen Vergleichsergebnissen durch Subtraktion bzw. Addition von $S_{l1}/2^{n-1} = 2^{N-1}/2^{n-1} = 2^2/2^{n-1} = 2^2/2$ ergeben.

Da für alle Kanäle $K_1$, ... $K_4$ im vorhergehenden, ersten Zyklus ausgehend von gleichen Referenzpegeln die gleichen Vergleichsergebnisse erhalten wurden, werden für alle Analogsignale $A_j$, j=1, ..., 4 die gleichen zu setzenden Referenzpegel bzw. Werte für die zu setzenden Steuersignal ermittelt, so dass der Index 1 nur den einzigen Wert 1 annimmt. Es ist also $S_{12} = S'_{j2}=S_{11}+S_{11}/2^{n-1} = S_{11}+S_{11}/2$, L(j)=1 f. j=1, ..., 4.

Es werden nun im Beispiel wiederum alle Analogsignalpegel parallel mit dem Referenzpegel des Referenzsignals $R_{12}$, der dem für die Analogsignale gleich zu setzenden Steuersignalwert $S_{12}$ entspricht, verglichen.

Gemäß dem Ergebnis des Vergleichs sind für die Kanäle $K_1$, $K_2$ und $K_3$ die Pegel kleiner als der Referenzpegel $R_{12}$, während für den Kanal $K_4$ der Pegel größer als der Referenzpegel $R_{12}$ ist, so dass die Vergleichssignale $C_{jL(j)2}=C_{j12}$ die Werte 0b für j=1,2,3 und 1b für j=4 annehmen.

9

In der dritten Ebene (n=3) sind theoretisch 4 Knoten, d.h. zu setzende Referenzpegel von Referenzsignalen bzw. entsprechende Steuersignale $S'_{j3}$ möglich. Die Werte ergeben sich, wie oben ausgeführt, aus den entsprechenden Referenzpegeln bzw. Werten des Steuersignals der vorhergehenden Ebene und den dabei erzielbaren Vergleichsergebnissen.

Im Beispiel werden für die Kanäle $K_1$, $K_2$ und $K_3$ mit gleichen Vergleichsergebnissen bei gleichen für sie ermittelten Referenzpegeln bei dem Vergleich in der zweiten Ebene als zu setzende Referenzpegel bzw. Werte des Steuersignals die Werte $S'_{j3}= S_{12}-2^3/2^2$, j=1, 2, 3 ermittelt, während sich für den Kanal $K_4$ als zu setzender Wert $S'_{j3}=S_{12}+2^3/2^2$, j=4 ergibt. Die anderen möglichen in Fig. 2 gezeigten Werte $S'_{j3}$ werden überhaupt nicht als zu setzende Referenzpegel bzw. Werte des Steuersignals ermittelt. Es gibt daher nur zwei voneinander verschiedene zu setzende Steuersignalwerte $S_{13}$ bzw. Referenzpegel $R_{13}$ mit 1=1 und 2, nämlich $S_{13}=S'_{j3}=5$ für j=1, 2, 3 und $S_{23}=S'_{43}=7$.

Unterhalb der dritten Ebene bzw. am Ende des dritten und letzten Zyklus treten nun theoretisch 8 verschiedene mögliche Werte für die zu bildenden Digitalsignale auf, die in Fig. 2 durch Rechtecke dargestellt sind, in die die entsprechenden Werte für das jeweilige Digitalsignal eingetragen sind. In der Zeile darunter sind nochmals die zur Ermittlung der Werte verwendeten Formeln dargestellt.

Im Beispiel der Kanäle $K_1$ bis $K_4$ wird im dritten Zyklus zunächst der Referenzpegel auf den dem Steuersignalwert $S_{13}$ für 1= 1 entsprechenden Referenzpegel $R_{13}$ gesetzt. 1=1 entspricht dabei den Indizes j=1, 2, 3, so dass L(1)=L(2) =L(3)=1 ist.

Es werden dann die Pegel aller Analogsignale bzw. Kanäle parallel mit diesem Referenzpegel verglichen.

Da der Pegel des Analogsignals des Kanals $K_2$ kleiner als der dem Steuersignalwert $S_{13}$ entsprechende Referenzpegel ist, wird für dieses Analogsignal aus dem für dieses ermittelten Referenzpegel bzw. Steuersignalwert $S_{13}$ und dem Vergleichsergebnis bzw. dem Vergleichssignal $C_{j13} = 0b$ der Digitalwert $D_j = S_{13}-1 = 4$, j=2 ermittelt.

Die Pegel der Analogsignale der Kanäle $K_1$ und $K_3$ sind größer als der dem Steuersignalwert $S_{13}$ entsprechende Referenzpegel, so dass für diese Analogsignale aus dem für diese ermittelten Referenzpegel $R_{13}$ und dem Vergleichsergebnis bzw. dem Vergleichssignal $C_{j13}=1b$ der Digitalwert $D_j = S_{13} = 5$, j=1, 3 ermittelt wird.

Das Vergleichssignal für das Analogsignal $A_4$ bzw. den Kanal $K_4$ wird nicht weiter verwendet, da der verwendete Referenzpegel nicht für dieses ermittelt wurde.

Für den Kanal $K_4$ wird auf der Basis des Steuersignalwerts $S_{12} =S'_{42}$ bzw. des entsprechenden Referenzpegels $R_{12}$ und des entsprechenden Vergleichssignals $C_{j12}$ für j=4 im vorhergehenden Zyklus der dem Referenzpegel entsprechende, zu setzende Steuersignalwert $S'_{43}$ mit dem zuvor angegebenen Wert ermittelt und als Steuersignalwert $S_{13}$ für 1=2 gesetzt.

Es erfolgt dann wiederum ein Vergleich der Pegel aller Analogsignale mit dem Referenzpegel, wobei allerdings nur das dabei für den Kanal $K_4$ gebildete Vergleichssignal $C_{423}$ weiter verwendet wird.

Da der Pegel des Analogsignals des Kanals $K_4$ größer als der dem Steuersignalwert $S_{23}$ entsprechende Referenzpegel $R_{23}$ ist, wird für das Analogsignal $A_4$ aus dem für dieses ermittelten Referenzpegel $R_{23}$ bzw. Steuersignalwert $S_{23}$ und dem Vergleichsergebnis bzw. dem Vergleichssignal $C_{423}=1b$ der Digitalwert $D_j = S_{23} = 7$, j=4 ermittelt.

Das Verfahren kann daher auch so aufgefasst werden, dass für jeden Kanal dem Wägeverfahren entsprechende Schritte durchgeführt werden, wobei jedoch auf einer Ebene auftretende gleiche Referenzpegel für verschiedene Kanäle nur einmal gesetzt und entsprechende Vergleiche parallel für alle Kanäle durchgeführt werden. Die Auswahl der für die Analog-Digital-Wandlung für einen bestimmten Kanal zu verwertenden Vergleichsergebnisse bzw. -signale erfolgt dann durch die Auswerteeinrichtung.

Da die Referenzpegel bzw. Steuersignalwerte jeweils durch entsprechende Vergleichsergebnisse als Funktion der Zyklusnummer für die vorhergehenden Zyklen gegeben sind, können prinzipiell statt der Referenzpegel bzw. Steuersignalwerte auch nur die Vergleichsergebnisse unter Berücksichtigung ihrer Reihefolge zur Bestimmung des jeweiligen Digitalwertes herangezogen werden.

Das Verfahren erlaubt eine sehr schnelle Verarbeitung der Analogsignale. Sind die Pegel aller Analogsignale so ähnlich, insbesondere gleich, dass für sie in jedem Zyklus die gleichen Vergleichsergebnisse erhalten werden, so erhält man die minimale Anzahl $S_{min}$ von Setzungen des Referenzpegels. Da in jedem Zyklus der Referenzpegel nur einmal gesetzt wird, ist

$$s_{min} = N.$$

Die größte Anzahl von Setzungen des Referenzpegels ergibt sich, wenn die Pegel der Analogsignale derart sind, dass bis zu einem letzten solchen Zyklus $n_{max}$ jeweils alle möglichen Referenzpegel gesetzt werden müssen, d.h. in allen Ebenen bis zur Ebene $n_{max}$ alle Knoten durchlaufen werden.

Da theoretisch mögliche Knoten in einem aktuellen Zyklus durch Vergleich an einem Knoten in dem vorhergehenden Zyklus entstehen, gibt es im Zyklus n bzw. in der Ebene n $2^{n-1}$ mögliche verschiedene Referenzpegel bzw.

Knoten. $n_{max}$ ergibt sich daher zu

$$n_{\mathrm{max}} = lb(M) + 1,$$

wobei lb(x) die größte ganze Zahl y bezeichnet, für die gilt, dass $2^y$ kleiner oder gleich x ist.

In dem nächsten Zyklus werden dann nur noch M verschiedene Referenzpegel gesetzt, da nicht mehr Analogsignale verarbeitet werden.

Insgesamt ergibt sich daher in diesem ungünstigen Fall die Gesamtzahl der Setzungen des Referenzpegels und der parallelen Vergleiche mit diesen zu:

$$
\begin{aligned}
s_{\mathrm{max}} &= \sum_{i=1}^{n_{\mathrm{max}}} 2^{i-1} + M \cdot \left( N - n_{\mathrm{max}} \right) \\
&= 2^{n_{\mathrm{max}}} - 1 + M \cdot \left( N - n_{\mathrm{max}} \right)
\end{aligned}
$$

Ist $M > 2^{N-1}$, so gilt

$$s_{\mathrm{max}} = 2^N - 1 .$$

Diese Ergebnisse können mit der Gesamtzahl der Setzungen bei einfachen, seriell arbeitenden Verfahren verglichen werden. Beispielsweise wären bei Verwendung eines nicht der Erfindung entsprechenden Multiplexverfahrens bzw. eines entsprechenden gewöhnlichen Analog-Digital-Wandlers, bei dem die parallelen Analogsignale bzw. entsprechende Abschnitte der Analogsignale auf den Kanälen durch einen Multiplexer in eine zeitliche Folge von Analogsignale gebracht und mit dem bekannten Wägeverfahren digitalisiert würden, für alle Analogsignale alle Referenzpegel zu setzen, so dass sich die Anzahl der Setzungen der Referenzpegel in diesem Fall zu

$$s_{\mathit{Multiplex}} = M * N$$

ergäbe.

Im günstigsten Fall ergibt sich damit eine relative Einsparung des Zeitaufwands gegenüber dem beschriebenen Multiplexverfahren von

$$\varepsilon_{\mathrm{max}} = \frac{s_{\mathit{Multiplex}} - s_{\mathrm{min}}}{s_{\mathit{Multiplex}}} = 1 - \frac{1}{M}$$

und im ungünstigsten Fall von

$$
\begin{aligned}
\varepsilon_{\mathrm{min}} &= \frac{s_{\mathit{Multiplex}} - s_{\mathrm{max}}}{s_{\mathit{Multiplex}}} \\
&= 1 - \frac{2^{n_{\mathrm{max}}} - 1 + M \cdot \left( N - n_{\mathrm{max}} \right)}{N \cdot M},
\end{aligned}
$$

beziehungsweise, falls $M > 2^{N-1}$ ist, von

$$\varepsilon_{\min} = \frac{S_{Multiplex} - S_{\max}}{S_{Multiplex}}$$

$$= 1 - \frac{2^N - 1}{N \cdot M}.$$

Bei 16 Kanälen und 8 Bit Auflösung ergibt sich beispielsweise mit M=16 und N=8

$$\varepsilon_{\max} = 1 - \frac{1}{16} \approx 94\%$$

und

$$\varepsilon_{\min} \approx 38\%,$$

d.h. eine deutliche Erhöhung der Erfassungsfrequenz selbst im ungünstigsten Fall. Im statischen Mittel wird die Reduktion des Zeitaufwands zwischen $\varepsilon_{\min}$ und $\varepsilon_{\max}$ liegen.

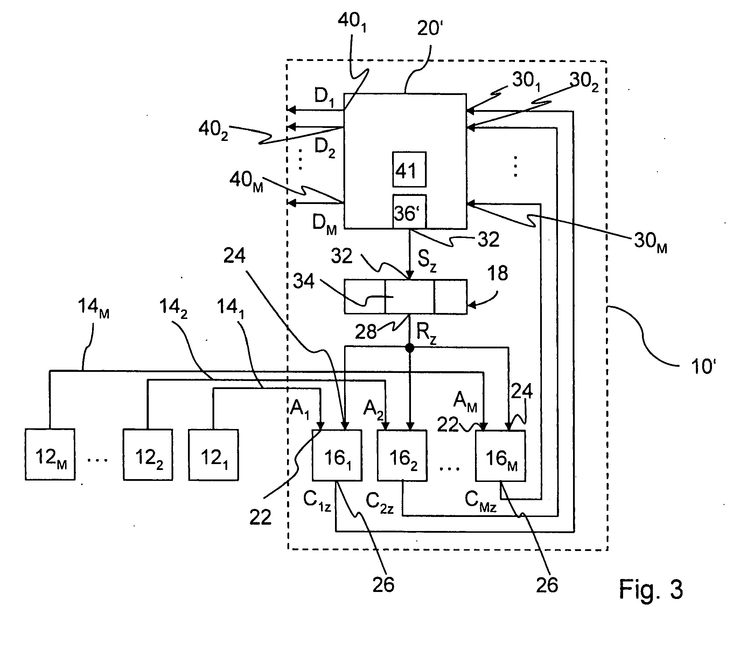

Bei einem Analog-Digital-Wandler 10' nach Fig. 3 ist gegenüber dem Analog-Digital-Wandler 10 des erfindungsgemäßen Ausführungsbeispiels lediglich die Auswerteeinrichtung 20 durch eine Auswerteeinrichtung 20' ersetzt. Für alle anderen Teile des Ausführungsbeispiels werden die gleichen Bezugszeichen wie in dem erfindungsgemäßen Ausführungsbeispiel verwendet und es gelten die gleichen Erläuterungen entsprechend.

Die Auswerteeinrichtung 20' unterscheidet sich von der Auswerteeinrichtung 20 durch die Ausbildung der Auswertelogik, eine Erfassungseinrichtung 41 und die Steuereinrichtung 36'. Die Steuereinrichtung 36' weist einen einfachen digitalen Zähler auf, der in jeweils einem Zyklus ausgehend von einem fest vorgegebenen, gleichen Anfangswert in dem Zyklus für eine vorgegebene Anzahl von Schritten seinen Zählerstand um 1 erhöht und das Resultat als Steuersignal $S_z$ an den Referenzsignalgenerator 18 ausgibt, wobei z ein den Zählerstand wiedergebender Index ist.

Der Referenzpegel $R_z$ des Referenzsignals wird daher durch Hochzählen des Zählers bzw. der Steuereinrichtung 36' in gleichen Schritten bis zu einem maximalen Wert erhöht.

Die Erfassungseinrichtung 41 ist dazu ausgebildet, bei Änderung eines Vergleichssignals angesteuert durch die Auswertelogik den Wert des Zählers auszulesen.

Die Auswertelogik ist zur Durchführung entsprechender Schritte eines Verfahrens zur Analog-Digital-Wandlung ausgebildet.

Bei dem Verfahren wird in aufeinander folgenden Zyklen durch Erhöhen des Zählers und Ausgabe eines entsprechenden Steuersignals $S_z$ der Referenzpegel $R_z$ des Referenzsignals jeweils ausgehend von dem gleichen Anfangswert in jedem Zyklus in gleichen Schritten bis zu einem-maximalen Wert erhöht, der insbesondere durch die Anzahl der zur digitalen Darstellung der Analogsignalpegel verwendeten Bit bestimmt sein kann.

Die Komparatoren $16_1$, ..., $16_M$ vergleichen dauernd im Wesentlichen parallel die Pegel der Analogsignale $A_j$ mit dem aktuellen Referenzpegel $R_z$ und bilden die Vergleichsergebnisse wiedergebende Vergleichssignale $C_{jz}$ , j=1, ..., M, die der Auswerteeinrichtung 20' im Wesentlichen parallel zugeführt werden.

In der Auswerteeinrichtung 20' wird bei einer Änderung des Vergleichssignals $C_{jz}$ für ein entsprechendes Analogsignal $A_j$ der Zähler 36' bzw. die Steuereinrichtung ausgelesen und der ausgelesene Wert als digitaler Wert für den entsprechenden Pegel des Analogsignals $A_j$ verwendet, wofür dann ein entsprechendes Digitalsignal $D_j$ gebildet wird.

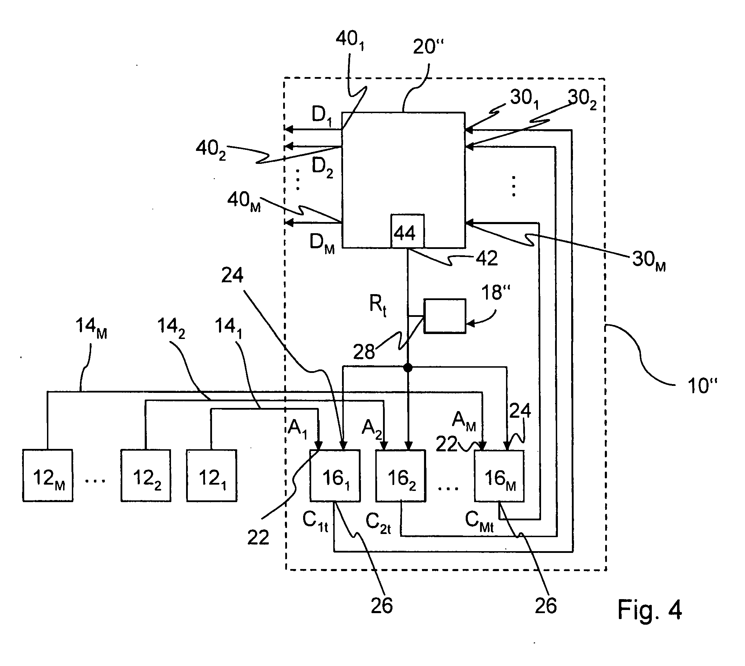

Bei einem schematisch in Fig. 4 gezeigten Analog-Digital-Wandler 10" sind gegenüber dem Analog-Digital-Wandler 10 des erfindungsgemäßen Ausführungsbeispiels die Auswerteeinrichtung 20 durch eine Auswerteeinrichtung 20" und der Referenzsignalgenerator 18 durch einen Referenzsignalgenerator 18" ersetzt. Für alle anderen Teile des Ausführungsbeispiels werden die gleichen Bezugszeichen wie in dem erfindungsgemäßen Ausführungsbeispiel verwendet und es gelten die gleichen Erläuterungen entsprechend.

Der Referenzsignalgenerator 18" weist einen Sägezahngenerator auf, der ein Referenzsignal mit einem vorgegebenen zeitlichen Referenzpegelverlauf erzeugt, das über den Referenzsignalausgang 28 an die Referenzsignaleingänge 24 der Komparatoren $14_1$, ... $14_M$ abgegeben wird. Der Referenzsignalausgang 28 ist weiterhin mit einem Referenzsignaleingang 42 der Auswerteeinrichtung 20" verbunden.

Die Auswerteeinrichtung 20" weist keine Steuereinrichtung auf. Dafür ist eine Erfassungseinrichtung 44 zur Zeiterfassung vorgesehen, die mit dem Referenzsignaleingang 42 verbunden ist. Die Erfassungseinrichtung ist insbesondere so ausgebildet, dass sie bei einem Rücksprung des sägezahnförmigen Referenzsignals in einen vorgegebenen Startzustand bzw. auf einen Startwert gesetzt wird und dass aus ihr im Folgenden ein den zeitlichen Abstand von dem Rücksprung wiedergebender Wert bzw. ein entsprechendes Signal auslesbar ist.

Die Auswertelogik der Auswerteeinrichtung 20" ist zur Durchführung entsprechender Schritte eines Verfahrens zur Analog-Digital-Wandlung ausgebildet.

Bei diesem Verfahren wird der Referenzpegel $R_t$ des Referenzsignals in Abhängigkeit von der Zeit t zyklisch linear bis zu einem Maximalwert erhöht.

Die Komparatoren $16_1$, ..., $16_M$ vergleichen dauernd im Wesentlichen parallel die Pegel der Analogsignale $A_j$, j=1, ..., M mit dem aktuellen Referenzpegel $R_t$ und bilden die Vergleichsergebnisse wiedergebende Vergleichssignale $C_{jt}$ für j=1, ..., M, die der Auswerteeinrichtung 20" im Wesentlichen parallel zugeführt werden.

In der Auswerteeinrichtung 20" wird zum einen bei einem Zurückspringen des Referenzpegels $R_t$ die Erfassungseinrichtung 44 auf den Startwert gesetzt und eine Zeiterfassung neu gestartet.

Bei einer Änderung des Vergleichssignals $C_{jt}$ für ein entsprechendes Analogsignal $A_j$ wird aus der Erfassungseinrichtung 44 ein Wert für die seit dem Rücksprung des sägezahnförmigen Referenzsignals bzw. Setzen des Startzustands vergangenen Zeit ausgelesen. Anhand der vorgegebenen, bekannten Änderungsgeschwindigkeit des Referenzpegels und des erfassten Zeitwertes wird dann ein digitaler Wert bestimmt, der näherungsweise den Analogsignalpegel wiedergibt. Ein entsprechendes Digitalsignal $D_j$ wird gebildet und über einen entsprechenden Ausgang abgegeben.

Bei einer bevorzugten Ausführungsform der Erfindung sind den Analogsignaleingängen der Komparatoren jeweils Erfassungs- und Halteschaltungen vorgeschaltet, die mit der Auswerteeinrichtung verbunden sind. Auf ein Signal der Auswerteeinrichtung hin, das bei der Ermittlung jeweils eines Digitalsignals für alle Kanäle mit oder unmittelbar nach der Bildung des jeweils letzten Digitalsignals abgegeben wird, wird dabei der Pegel des jeweiligen Analogsignals der entsprechenden Analogsignalquelle neu erfasst und bis zum Empfang des nächsten Signals von der Auswerteeinrichtung ein Analogsignal mit dem erfassten Pegel an den Analogsignaleingang des entsprechenden Komparators abgegeben.

<u>Bezugszeichenliste</u>

| | |
|---|---|
| 10, 10', 10" | Analog-Digital-Wandler |
| $12_1$, $12_2$, $12_M$ | Analogsignalquellen |
| $14_1$, $14_2$, $14_M$ | Kanäle |
| $16_1$, $16_2$, $16_M$ | Komparatoren |
| 18, 18" | Referenzsignalgeneratoren |
| 20, 20', 20" | Auswerteeinrichtung |
| 22 | Analogsignaleingänge |
| 24 | Referenzsignaleingänge |
| 26 | Vergleichssignalausgänge |
| 28 | Referenzsignalausgang |
| $30_1$, ..., $30_M$ | Vergleichssignaleingänge |
| 32 | Steuersignaleingang |
| 34 | Digital-Analog-Wandler |
| 36, 36' | Steuereinrichtungen |
| 38 | Steuersignalausgang |
| $40_1$, ..., $40_M$ | Digitalsignalausgänge |
| 41 | Erfassungseinrichtung |
| 42 | Referenzsignaleingang |
| 44 | Erfassungseinrichtung |
| | |
| $A_j$ | Analogsignale bzw. -pegel |
| $C_{jln}$, $C_{jz}$, $C_{jt}$ | Vergleichssignale bzw. -pegel |
| $D_j$ | Digitalsignale bzw. -werte |
| $R_{ln}$, $R_z$, $R_t$ | Referenzsignale bzw. -pegel |
| $S_{ln}$, $S_z$ | Steuersignale bzw. -pegel |

**Patentansprüche**

1. Verfahren zur Wandlung von Analogsignalen wenigstens zweier Kanäle ($14_1$, ... $14_M$) in entsprechende, jeweils deren Pegel darstellende Digitalsignale,

bei dem ein Referenzsignal mit einem sich zeitlich ändernden Referenzpegel gebildet wird,

die Pegel der Analogsignale wenigstens zu verschiedenen Zeitpunkten im Wesentlichen parallel mit dem jeweiligen Referenzpegel des Referenzsignals verglichen und für die Analogsignale jeweils entsprechende, das Ergebnis des jeweiligen Vergleichs wiedergebende Vergleichssignale gebildet werden, und

für jedes Analogsignal auf der Basis wenigstens eines der Vergleichssignale für das jeweilige Analogsignal ein dessen Pegel wiedergebendes Digitalsignal gebildet wird,

**dadurch gekennzeichnet,**

**dass** in einem ersten Zyklus der Referenzpegel auf einen ersten vorbestimmten Wert gesetzt wird, die Pegel der Analogsignale mit dem Referenzpegel verglichen und für die Analogsignale entsprechende Vergleichssignale gebildet werden,

in aufeinander folgenden Zyklen für jedes Analogsignal ein in dem Zyklus zu setzender Wert für den Referenzpegel ermittelt wird, der jeweils in Abhängigkeit von der Anzahl der seit dem ersten Zyklus abgearbeiteten Zyklen und von Vergleichsergebnissen für das jeweilige Analogsignal in den vorhergehenden Zyklen oder dem für das jeweilige Analogsignal ermittelten Wert des Referenzpegels im vorhergehenden Zyklus in Verbindung mit dem entsprechenden Vergleichsergebnis für das jeweilige Analogsignal des vorhergehenden Zyklus bestimmt ist, der Referenzpegel in dem Zyklus auf alle voneinander verschiedenen ermittelten, zu setzenden Werte gesetzt wird, und die Pegel der Analogsignale parallel mit dem jeweiligen Referenzpegel verglichen und das Ergebnis des jeweiligen Vergleichs wiedergebende Vergleichssignale gebildet werden,

und **dass** für jedes Analogsignal in Abhängigkeit von Vergleichsergebnissen für das jeweilige Analogsignal, die jeweils bei einem für das Analogsignal ermittelten Wert des Referenzpegel bestimmt wurden, oder wenigstens einem der Vergleichsergebnisse für das Analogsignal, die jeweils bei einem für das Analogsignal ermittelten Referenzpegel bestimmt wurden, und wenigstens einem für das Analogsignal ermittelten Wert des Referenzpegels ein den Pegel des Analogsignals wiedergebendes Digitalsignal gebildet wird.

2. Verfahren nach Anspruch 1,
**dadurch gekennzeichnet,**
**dass** die Pegel der Analogsignale durch eine vorgegebene Anzahl von Bits dargestellt werden, und
**dass** der erste Wert des Referenzpegels einem durch das höchstwertigen Bit dargestellten Pegel entspricht.

3. Verfahren nach Anspruch 2,
**dadurch gekennzeichnet,**
**dass** der zu setzende Wert des Referenzpegels für ein Analogsignal in einem Zyklus n gegenüber dem entsprechenden, in dem vorhergehenden Zyklus ermittelten, zu setzenden Wert des Referenzpegels für das Analogsignal um den Wert des Referenzpegels im ersten Zyklus dividiert durch $2^{n-1}$ reduziert ist, wenn im vorhergehenden Zyklus der Pegel des Analogsignals kleiner als der Referenzpegel war, während dieser auf den für das Analogsignal als zu setzend ermittelten Wert gesetzt war, und um den Wert des Referenzpegels im ersten Zyklus dividiert durch $2^{n-1}$ erhöht ist, wenn im vorhergehenden Zyklus der Pegel des Analogsignals größer als der Referenzpegel war, während dieser auf den für das Analogsignal als zu setzend ermittelten Wert gesetzt war,
wobei n die Ordinalzahl des Zyklus bezeichnet.

4. Verfahren nach einem der vorhergehenden Ansprüche,
**dadurch gekennzeichnet,**
**dass** die Referenzsignale durch eine Digital-Analog Wandlung gebildet werden.

5. Verfahren nach einem der vorhergehenden Ansprüche,
**dadurch gekennzeichnet,**
**dass** der Pegel wenigstens eines der Analogsignale während der Dauer der Bildung jeweils eines Digitalwerts für alle Kanäle ($14_1$, ... $14_M$) im Wesentlichen konstant gehalten wird.

6. Analog-Digital-Wandler zur Wandlung von Analogsignalen wenigstens zweier Kanäle ($14_1$, ... $14_M$) in entsprechende, jeweils deren Pegel darstellende Digitalsignale, mit
einem Referenzsignalgenerator (18; 18") zur Bildung eines zeitlich veränderlichen Referenzsignals und zur Abgabe des Referenzsignals über einen Referenzsignalausgang (28),
jeweils einem Komparator ($16_1$, ... $16_M$) für jeden der Kanäle ($14_1$, ... $14_M$), der einen Analogsignaleingang (22) zur Zuführung des Analogsignals des entsprechenden Kanals ($14_1$, ..., $14_M$) und einen mit dem Referenzsignalausgang (28) verbundenen Referenzsignaleingang (24) aufweist und mittels dessen der Pegel des jeweiligen Analogsignals mit einem Referenzpegel des Referenzsignals vergleichbar und ein entsprechendes, ein Ergebnis des Vergleichs wiedergebendes Vergleichssignal über einen Vergleichssignalausgang (26) des Komparators ($16_1$, ... $16_M$) ausgebbar ist, und

einer Auswerteeinrichtung (20; 20'; 20"), die mit den Vergleichssignalausgängen der Komparatoren ($16_1$, ... $16_M$) und mit dem Referenzsignalgenerator (18; 18") verbunden ist und mittels derer in Abhängigkeit von den empfangenen Vergleichssignalen für die Analogsignale entsprechende, die Pegel der Analogsignale wiedergebende Digitalsignale bildbar und abgebbar sind,

**dadurch gekennzeichnet,**

**dass** der Referenzsignalgenerator (18) durch Steuersignale an einem Steuersignaleingang (32) des Referenzsignalgenerators (18) steuerbar ist, und

**dass** die Auswerteeinrichtung (20) eine Steuereinrichtung (36) aufweist, die mit dem Steuersignaleingang (32) verbunden ist und mittels derer der Referenzsignalgenerator (18) so steuerbar ist, dass

in einem ersten Zyklus der Referenzpegel auf einen ersten vorbestimmten Wert gesetzt wird, und

in aufeinander folgenden Zyklen für jedes Analogsignal ein in dem Zyklus zu setzender Wert für den Referenzpegel ermittelt wird, der jeweils in Abhängigkeit von der Anzahl der seit dem ersten Zyklus abgearbeiteten Zyklen und von Vergleichsergebnissen für das jeweilige Analogsignal in den vorhergehenden Zyklen oder dem für das jeweilige Analogsignal ermittelten Wert des Referenzpegels im vorhergehenden Zyklus in Verbindung mit dem entsprechenden Vergleichsergebnis für das jeweilige Analogsignal des vorhergehenden Zyklus bestimmt ist, und der Referenzpegel in dem Zyklus auf alle voneinander verschiedenen ermittelten, zu setzenden Werte gesetzt wird,

und **dass** die Auswerteeinrichtung (20) weiter so ausgebildet ist, dass für jedes Analogsignal in Abhängigkeit von Vergleichsergebnissen für das jeweilige Analogsignal, die jeweils bei einem für das Analogsignal ermittelten des Referenzpegel bestimmt wurden, oder wenigstens einem der Vergleichsergebnisse für das Analogsignal, die jeweils bei einem für das Analogsignal ermittelten Referenzpegel bestimmt wurden, und wenigstens einem für das Analogsignal ermittelten Wert des Referenzpegels Daten ermittelbar sind, die den Pegel des Analogsignals wiedergeben.

7. Analog-Digital-Wandler nach Anspruch 6,
**dadurch gekennzeichnet,**
**dass** die Auswerteeinrichtung (20) so ausgebildet ist, dass die Pegel der Analogsignale durch eine vorgegebene Anzahl von Bits dargestellt werden, und
**dass** die Steuereinrichtung (36) so ausgebildet ist, dass der erste Wert des Referenzpegels einem durch das höchstwertige Bit dargestellten Pegel entspricht.

8. Analog-Digital-Wandler nach Anspruch 7,
**dadurch gekennzeichnet,**
**dass** die Steuereinrichtung (36) so ausgebildet ist, dass der zu setzende Wert des Referenzpegels für ein Analogsignal in einem Zyklus n gegenüber dem entsprechenden, in dem vorhergehenden Zyklus ermittelten, zu setzenden Wert des Referenzpegels für das Analogsignal um den Wert des Referenzpegels im ersten Zyklus dividiert durch $2^{n-1}$ reduziert ist, wenn im vorhergehenden Zyklus der Pegel des Analogsignals kleiner als der Referenzpegel war, während dieser auf den für das Analogsignal als zu setzend ermittelten Wert gesetzt war, und um den Wert des Referenzpegels im ersten Zyklus dividiert durch $2^{n-1}$ erhöht ist, wenn im vorhergehenden Zyklus der Pegel des Analogsignals größer als der Referenzpegel war, während dieser auf den für das Analogsignal als zu setzend ermittelten Wert gesetzt war,
wobei n die Ordinalzahl des Zyklus bezeichnet.

9. Analog-Digital-Wandler nach einem der Ansprüche 6 bis 8,
**dadurch gekennzeichnet,**
**dass** der Referenzsignalgenerator (18) einen Digital-Analog-Wandler (34) umfasst, dessen Ausgang mit dem Referenzsignalausgang (28) verbunden ist.

10. Analog-Digital-Wandler nach einem der Ansprüche 6 bis 9,
**gekennzeichnet durch**
wenigstens eine vor den Analogsignaleingang wenigstens eines der Komparatoren geschaltete Erfassungs- und Halteschaltung.

**Claims**

1. Method for the conversion of analog signals of at least two channels ($14_1$, ... $14_M$) into corresponding digital signals which represent their respective levels,

in which a reference signal with a temporally varying reference level is formed,

the levels of the analog signals are compared substantially in parallel at least at different points in time with the respective reference level of the reference signal and respective corresponding comparison signals for the analog signals which reproduce the results of the respective comparison are formed, and

for each analog signal a digital signal which reproduces its level is formed on the basis of at least one of the comparison signals for the respective analog signal,

   **characterized in that,**

   in a first cycle the reference level is set to a first predetermined value, the level of the analog signals is compared with the reference level and corresponding comparison signals are formed for the analog signals;

   in successive cycles for each analog signal a value for the reference signal which is to be set **in that** cycle is established, which is determined in each case in dependence on the number of cycles which had been worked through since the first cycle and on comparison results for the respective analog signal in the preceding cycles or the value of the reference level which had been established for the respective analog signal in the preceding cycle in conjunction with the corresponding comparison result for the respective analog signal of the preceding cycle, **in that** cycle the reference level is set to all established values to be set which differ from one another, and the level of the analog signals is compared in parallel with the respective reference level and comparison signals which reproduce the result of the respective comparison are formed; and **in that**

   for each analog signal a digital signal which reproduces the level of the analog signal is formed in dependence on comparison results for the respective analog signal which were determined in each case at a value of the reference level which was established for the analog signal, or at least on one of the comparison results for the analog signal which were determined at a reference level which was established for the respective analog signal, and on at least one value of the reference level which was established for the analog signal.

2. Method in accordance with claim 1,
   **characterized in that**,
   the level of the analog signals is represented by a predetermined number of bits; and **in that**
   the first value of the reference level corresponds to a level which is represented by the highest value bit.

3. Method in accordance with claim 2,
   **characterized in that,**
   the value of the reference level for an analog signal which is to be set in a cycle n is reduced, with respect to the corresponding value of the reference level for the analog signal which is to be set which was established in the preceding cycle, by the value of the reference level in the first cycle divided by $2^{n-1}$ if in the preceding cycle the level of the analog signal was lower than the reference level while the latter was set to the value which was established as that to be set for the analog signal, and is increased by the value of the reference level in the first cycle divided by $2^{n-1}$ if, in the preceding cycle, the level of the analog signal was higher than the reference level while the latter was set to the value which was established as that to be set for the analog signal,
   where n designates the ordinal number of the cycle.

4. Method in accordance with at least one of the preceding claims,
   **characterized in that**,
   the reference signals are formed by a digital-analog conversion.

5. Method in accordance with at least one of the preceding claims,
   **characterized in that,**
   the level of at least one of the analog signals is held substantially constant during the time required for forming in each case one digital value for all channels ($14_1$, ... $14_M$).

6. Analog-digital converter for the conversion of analog signals of at least two channels ($14_1$, ... $14_M$) into corresponding digital signals which represent their respective levels, comprising

   a reference signal generator (18; 18'') for forming a temporally varying reference signal and for outputting the reference signal via a reference signal output (28),

   one comparator ($16_1$, ... $16_M$) each for each of the channels ($14_1$, ... $14_M$), which has an analog signal input (22) for supplying the analog signal of the corresponding channel ($14_1$, ... $14_M$) and a reference signal input (24) which is connected to the reference signal output (28) and by means of which the level of the respective analog signal can be compared with a reference level of the reference signal and a corresponding comparison signal which reproduces a result of the comparison can be output via a comparison signal output (26) of the comparator ($16_1$, ... $16_M$), and an evaluation device (20; 20'; 20") which is connected to the comparison signal outputs of the comparators ($16_1$, ... $16_M$) and to the reference signal generator (18; 18") and by means of which corresponding digital signals which reproduce the levels of the analog signals can be formed in dependence on the received comparison signals for the analog signals and be transmitted,

**characterized in that**,

the reference signal generator (18) can be controlled by control signals at a control signal input (32) of the reference signal generator (18); and **in that**

the evaluation device (20) has a control device (36) which is connected to the control signal input (32) and by means of which the reference signal generator (18) can be controlled in such a manner that in a first cycle the reference level is set to a first predetermined value, and

in successive cycles for each analog signal a value for the reference level which is to be set **in that** cycle is established which is determined in each case in dependence on the number of cycles which had been worked through since the first cycle and on comparison results for the respective analog signal in the preceding cycles or on the value of the reference level for the respective analog signal which was established in the preceding cycle in conjunction with the corresponding comparison result for the respective analog signal of the preceding cycle, and the reference level is set to all established values to be set which are different from one another **in that** cycle; and **in that**

the evaluation device (20) is furthermore designed such that data which reproduce the level of the analog signal can be established for each analog signal in dependence on comparison results for the respective analog signal which in each case were determined at a reference level which was established for the analog signal, or were determined at at least one of the comparison results for the analog signal which were determined in each case at a reference level which was established for the analog signal, and for at least one value of the reference level which was established for the analog signal.

7. Analog-digital converter in accordance with claim 6,

**characterized in that**,

the evaluation device (20) is designed such that the levels of the analog signals are represented by a predetermined number of bits; and **in that**

the control device (36) is designed such that the first value of the reference level corresponds to a level which is represented by the highest value bit.

8. Analog-digital converter in accordance with claim 7,

**characterized in that**,

the control device (36) is designed such that the value of the reference level for an analog signal which is to be set in a cycle n is reduced with respect to the corresponding value of the reference level for the analog signal which is to be set which was established in the preceding cycle by the value of the reference level in the first cycle divided by $2^{n-1}$ if in the preceding cycle the level of the analog signal was lower than the reference level while the latter was set to the value which was established as that to be set for the analog signal, and is increased by the value of the reference level in the first cycle divided by $2^{n-1}$ if in the preceding cycle the level of the analog signal was higher than the reference level while the latter was set to the value which was established as that to be set for the analog signal,

where n designates the ordinal number of the cycle.

9. Analog-digital converter in accordance with any one of the claims 6 to 8,

**characterized in that**,

the reference signal generator (18) comprises a digital-analog converter (34), the output of which is connected to the reference signal output (28).

10. Analog-digital converter in accordance with at least one of the claims 6 to 9,

**characterized by**,

at least one sense and hold circuit which is placed ahead of the analog signal input of at least one of the comparators.

**Revendications**

1. Procédé pour la conversion de signaux analogiques d'au moins deux canaux ($14_1$...$14_M$) en signaux numériques correspondants représentant respectivement le niveau de ceux-ci,

dans lequel un signal de référence est formé avec un niveau de référence changeant dans le temps,

les niveaux des signaux analogiques étant comparés essentiellement parallèlement, au moins à différents moments, au niveau de référence respectif du signal de référence et pour les signaux analogiques, des signaux de comparaison respectifs correspondants reproduisant le résultat de la comparaison respective, sont formés, et

pour chaque signal analogique, un signal numérique reproduisant le niveau de celui-ci est formé sur la base d'au moins l'un des signaux de comparaison pour le signal analogique respectif,

**caractérisé en ce que**

dans un premier cycle, le niveau de référence est défini sur une première valeur prédéfinie, les niveaux des signaux analogiques sont comparés au niveau de référence et des signaux de comparaison correspondants sont formés pour les signaux analogiques,

dans des cycles se succédant pour chaque signal analogique, une valeur du niveau de référence à définir dans le cycle est déterminée pour le niveau de référence, valeur qui est définie respectivement en fonction du nombre de cycles exécutés depuis le premier cycle et en fonction des résultats de comparaison pour le signal analogique respectif dans les cycles précédents ou de la valeur du niveau de référence déterminée pour le signal analogique respectif dans le cycle précédent en association avec le résultat de comparaison correspondant pour le signal analogique respectif du cycle précédent, le niveau de référence dans le cycle est défini sur toutes les valeurs à définir déterminées et différentes les unes des autres, et les niveaux des signaux analogiques sont comparés parallèlement au niveau de référence respectif et le résultat de la comparaison respectif et des signaux de comparaison reproduisant le résultat de la comparaison respective sont formés,

et **en ce que** pour chaque signal analogique, en fonction des résultats de comparaison pour le signal analogique respectif, qui ont été définis respectivement selon une valeur du niveau de référence déterminée pour le signal analogique, ou d'au moins l'un des résultats de comparaison pour le signal analogique, qui ont été définis respectivement selon un niveau de référence déterminé pour le signal analogique, et au moins d'une valeur du niveau de référence déterminée pour le signal analogique, un signal numérique reproduisant le niveau du signal analogique est formé.

2. Procédé selon la revendication 1,
   **caractérisé en ce que**
   les niveaux des signaux analogiques sont représentés par un nombre prédéfini de bits, et
   la première valeur du niveau de référence correspond à un niveau représenté par le bit de la valeur la plus grande.

3. Procédé selon la revendication 2,
   **caractérisé en ce que**
   la valeur à définir du niveau de référence pour un signal analogique dans un cycle n est réduite de l'ordre de la valeur du niveau de référence du premier cycle divisées par $2^{n-1}$ par rapport à la valeur correspondante à définir du niveau de référence pour le signal analogique déterminé dans le cycle précédent, lorsque, dans le cycle précédent, le niveau du signal analogique était inférieur au niveau de référence alors que celui-ci était défini sur la valeur déterminée à définir pour le signal analogique, et est augmentée de l'ordre de la valeur du niveau de référence dans le premier cycle divisée par $2^{n-1}$, lorsque, dans le cycle précédent, le niveau du signal analogique était supérieur au niveau de référence alors que celui-ci était défini sur la valeur déterminée à définir pour le signal analogique, n désignant le chiffre ordinal du cycle.

4. Procédé selon l'une quelconque des revendications précédentes,
   **caractérisé en ce que**
   les signaux de référence sont formés par une conversion numérique-analogique.

5. Procédé selon l'une quelconque des revendications précédentes,
   **caractérisé en ce que**
   le niveau au moins de l'un des signaux analogiques est maintenu essentiellement constant pendant la durée de la formation respectivement d'une valeur numérique pour tous les canaux $(14_1...14_M)$.

6. Convertisseur analogique-numérique pour la conversion de signaux analogiques d'au moins deux canaux $(14_1... 14_M)$ en signaux numériques correspondants représentant chacun le niveau de ceux-ci, comprenand
   un générateur de signal de référence (18, 18') pour la formation d'un signal de référence modifiable dans le temps et pour l'émission du signal de référence par une sortie pour signaux de référence (28),
   respectivement un comparateur $(16_1...16_M)$ pour chacun des canaux $(14_1...14_M)$, qui présente une entrée pour signaux analogiques (22) pour l'alimentation du signal analogique du canal $(14_1...14_M)$ correspondant et une entrée pour signaux de référence (24) reliée à la sortie pour signaux de référence (28), et grâce auquel le niveau du signal analogique correspondant peut être comparé à un niveau de référence du signal de référence et un signal de comparaison reproduisant un résultat de la comparaison peut être sorti par une sortie pour signaux de comparaison (26) du comparateur ($16_1$...$16_M$), et

un dispositif d'analyse (20, 20', 20") qui est relié aux sorties pour signaux de comparaison des comparateurs ($16_1$... $16_M$) et au générateur de signaux de référence (18, 18") et au moyen duquel, en fonction des signaux de comparaison reçus pour les signaux analogiques, les niveau des signaux numériques reproduisant les signaux analogiques peuvent être formés et émis,
**caractérisé en ce que**

le générateur de signaux de référence (18) peut être commandé par des signaux de commande au niveau d'une entrée pour signaux de commande (32) du générateur de signaux de référence (18), et

le dispositif d'analyse (20) présente un dispositif de commande (36) qui est relié à l'entrée pour signaux de commande (32) et peut être commandé au moyen de celle du générateur de signaux de référence (18) de telle sorte que dans un premier cycle, le niveau de référence est défini sur une première valeur prédéfinie, et

que dans des cycles se succédant pour chaque signal analogique, une valeur du niveau de référence à définir dans le cycle est déterminée pour le niveau de référence, valeur qui est définie respectivement en fonction du nombre de cycles exécutés depuis le premier cycle et en fonction des résultats de comparaison pour le signal analogique respectif dans les cycles précédents ou de la valeur du niveau de référence déterminée pour le signal analogique respectif dans le cycle précédent en association avec le résultat de comparaison correspondant pour le signal analogique respectif du cycle précédent, et le niveau de référence dans le cycle est défini sur toutes les valeurs à définir déterminées et différentes les unes des autres,

et **en ce que** le dispositif d'analyse (20) est en outre réalisé de telle sorte que pour chaque signal analogique, en fonction de résultats de comparaison pour le signal analogique respectif, qui ont été définis respectivement selon une valeur du niveau de référence déterminée pour le signal analogique, ou d'au moins l'un des résultats de comparaison pour le signal analogique qui ont été définis respectivement selon un niveau de référence déterminé pour le signal analogique, et au moins d'une valeur du niveau de référence déterminée pour le signal analogique, un signal numérique reproduisant le niveau du signal analogique est formé.

7. Convertisseur analogique-numérique selon la revendication 6,
   **caractérisé en ce que**
   le dispositif d'analyse (20) est réalisé de telle sorte que les niveaux des signaux analogiques sont représentés par un nombre prédéfini de bits, et
   le dispositif de commande (36) est réalisé de telle sorte que la première valeur du niveau de référence correspond à un niveau représenté par le bit de la valeur la plus grande.

8. Convertisseur analogique-numérique selon la revendication 7,
   **caractérisé en ce que**
   le dispositif de commande (36) est réalisé de telle sorte que la valeur à définir du niveau de référence pour un signal analogique dans un cycle n est réduite de l'ordre de la valeur du niveau de référence du premier cycle divisées par $2^{n-1}$ par rapport à la valeur correspondante à définir du niveau de référence pour le signal analogique déterminée dans le cycle précédent, lorsque, dans le cycle précédent, le niveau du signal analogique était inférieur au niveau de référence alors que celui-ci était défini sur la valeur déterminée à définir pour le signal analogique, et est augmentée de l'ordre de la valeur du niveau de référence dans le premier cycle divisée par $2^{n-1}$, lorsque, dans le cycle précédent, le niveau du signal analogique était supérieur au niveau de référence alors que celui-ci était défini sur la valeur déterminée à définir pour le signal analogique,
   n désignant le chiffre ordinal du cycle

9. Convertisseur analogique-numérique selon l'une quelconque des revendications 6 à 8, **caractérisé en ce que**
   le générateur de signaux de référence (18) comprend un convertisseur analogique-numérique (34) dont la sortie est reliée à la sortie pour signaux de référence (28).

10. Convertisseur analogique-numérique selon l'une quelconque des revendications 6 à 9,
    **caractérisé par**
    au moins l'un des circuits de détection et d'arrêt connecté en amont de l'entrée pour signaux analogiques d'au moins l'un des comparateurs.

Fig. 1

Fig. 2

Fig. 3

EP 1 530 295 B1

Fig. 4